# EUROPEAN PATENT APPLICATION

(11) **EP 0 694 977 A2**
(43) Date of publication of application: **31.01.1996**
(21) Application number: 95111059.2
(22) Date of filing: 14.07.1995
(51) Int. Cl.: H01L 29/786, H01L 21/336, H01L 27/12, H01L 27/092

(54) **SOI-type semiconductor device with suppressed spread of depletion region**

(30) Priority: 14.07.1994 JP 162316/94
(71) Applicant: NEC CORPORATION, Tokyo (JP)
(72) Inventor: Yoshino, Akira, Minaato-ku, Tokyo (JP)
(74) Representative: Baronetzky, Klaus, Dipl.-Ing.

(57) **Abstract**

In a semiconductor device including a semiconductor substrate (1, 1'), an insulating layer (2) formed on the semiconductor substrate and a semiconductor layer (3) formed on the insulating layer, the impurity concentration of at least one part of the semiconductor substrate in the proximity of the insulating layer is rich, i.e., higher than that of the other part of the semiconductor substrate.

## Description

### BACKGROUND OF THE INVENTION

### Field of the Invention

The present invention relates to a silicon-on-insulator (SOI)-type semiconductor device.

### Description of the Related Art

Generally, in a metal oxide semiconductor (MOS) device (broadly, metal insulator semiconductor (MIS) device), in order to realize highly integrated circuits, the gate length has to be reduced; however, in this case, short channel effects are exhibited. That is, the threshold voltage is reduced, a duration between the source-drain is reduced, and the sub threshold current is increased. Generally, in order to suppress such adverse short channel effects, as the gate length is reduced, the impurity concentration of a channel region has to be increased. In this case, however, a p-n junction capacitance between a drain region and a substrate is increased, so that a time for charging and discharging the p-n junction capacitance is increased, thus reducing the operation speed.

On the other hand, SOI-type semiconductor devices have been broadly developed to reduce the above-described p-n junction capacitance.

A prior art SOI-type semiconductor device includes a monocrystalline silicon substrate of a P-type, for example, having a low impurity concentration, a silicon oxide layer formed on the silicon substrate, and a semiconductor layer including a source region, a drain region and a channel region therebetween. This will be explained later in detail.

In the above-described prior art SOI-type semiconductor device, however, since a depletion region is generated within the silicon substrate beneath the channel region, the absolute value of the threshold voltage is increased, and accordingly, the transistor drivability is unstable which reduces the operation speed.

### SUMMARY OF THE INVENTION

It is an object of the present invention to increase the operation speed of an SOI-type semiconductor device.

According to the present invention, in a semiconductor device including a semiconductor substrate, an insulating layer is formed on the semiconductor substrate and a semiconductor layer formed on the insulating layer, and the impurity concentration of at least one part of the semiconductor substrate in the proximity of the insulating layer is rich, i.e., higher than that of the other part of the semiconductor substrate. Thus, the rich impurity part of the semiconductor substrate prevents the growth of a depletion region toward a region of the semiconductor substrate beneath a channel region of the semiconductor layer.

### BRIEF DESCRIPTION OF THE DRAWINGS

The present invention will be more clearly understood from the description as set forth below, as compared with the prior art, with reference to accompanying drawings, wherein:
Fig. 1 is a cross-sectional view illustrating a prior art SOI-type substrate;
Fig. 2 is a cross-sectional view illustrating a prior art SOI-type MOS transistor;
Fig. 3A is a cross-sectional view illustrating a completely depleted SOI-type MOS transistor;
Fig. 3B is a cross-sectional view illustrating a partly depleted SOI-type MOS transistor;
Fig. 4 is a cross-sectional view illustrating a prior art SOI-type semiconductor device;
Fig. 5 is a cross-sectional view illustrating a first embodiment of the SOI-type semiconductor device according to the present invention;
Figs. 6A through 6D are cross-sectional views for explaining the manufacturing steps of the device of Fig. 5;
Fig. 7 is a cross-sectional view illustrating a second embodiment of the SOI-type semiconductor device according to the present invention;
Fig. 8 is a partial enlargement of the device of Fig. 7;
Figs. 9A through 9D are cross-sectional views for explaining the manufacturing steps of the device of Fig. 7;
Fig. 10 is a cross-sectional view illustrating a third embodiment of the SOI-type semiconductor device according to the present invention;
Figs. 11A through 11D are cross-sectional views for explaining the manufacturing steps of the device of Fig. 10;
Fig. 12 is a cross-sectional view illustrating a fourth embodiment of the SOI-type semiconductor device according to the present invention;
Figs. 13A through 13D are cross-sectional views for explaining the manufacturing steps of the device of Fig. 12;
Fig. 14 is a cross-sectional view illustrating a fifth embodiment of the SOI-type semiconductor device according to the present invention;
Figs. 15A through 15D are cross-sectional views for explaining the manufacturing steps of the device of Fig. 14;
Fig. 16 is a cross-sectional view illustrating a sixth embodiment of the SOI-type semiconductor device according to the present invention;
Figs. 17A through 17D are cross-sectional views for explaining the manufacturing steps of the device of Fig. 16;
Fig. 18 is a cross-sectional view illustrating a seventh embodiment of the SOI-type semiconductor device according to the present invention;
Figs. 19A through 19F are cross-sectional views for explaining the manufacturing steps of the device of Fig. 18;
Fig. 20 is a cross-sectional view illustrating an eighth embodiment of the SOI-type semiconductor device according to the present invention;
Figs. 21A through 21F are cross-sectional views for explaining the manufacturing steps of the device of Fig. 20;
Fig. 22 is a cross-sectional view illustrating a ninth embodiment of the SOI-type semiconductor device according to the present invention;
Fig. 23 is a cross-sectional view illustrating a tenth embodiment of the SOI-type semiconductor device according to the present invention;
Fig. 24 is a cross-sectional view illustrating an eleventh embodiment of the SOI-type semiconductor device according to the present invention;
Fig. 25 is a cross-sectional view illustrating a twelfth embodiment of the SOI-type semiconductor device according to the present invention;
Fig. 26 is a cross-sectional view illustrating a thirteenth embodiment of the SOI-type semiconductor device according to the present invention;
Fig. 27 is a cross-sectional view illustrating a fourteenth embodiment of the SOI-type semiconductor device according to the present invention;
Fig. 28 is a cross-sectional view illustrating a fifteenth embodiment of the SOI-type semiconductor device according to the present invention;
Fig. 29 is a cross-sectional view illustrating a sixteenth embodiment of the SOI-type semiconductor device according to the present invention;
Fig. 30 is a cross-sectional view illustrating a seventeenth embodiment of the SOI-type semiconductor device according to the present invention;
Fig. 31 is a cross-sectional view illustrating an eighteenth embodiment of the SOI-type semiconductor device according to the present invention;
Fig. 32 is a cross-sectional view illustrating a ninteenth embodiment of the SOI-type semiconductor device according to the present invention;
Fig. 33 is a cross-sectional view illustrating a twentieth embodiment of the SOI-type semiconductor device according to the present invention;
Fig. 34 is a cross-sectional view illustrating a twenty first embodiment of the SOI-type semiconductor device according to the present invention;
Figs. 35A through 35J are cross-sectional views for explaining the manufacturing steps of the device of Fig. 34;
Fig. 36 is a cross-sectional view illustrating a twenty second embodiment of the SOI-type semiconductor device according to the present invention;
Figs. 37A through 37K are cross-sectional views for explaining the manufacturing steps of the device of Fig. 37;
Fig. 38 is a cross-sectional view illustrating a twenty third embodiment of the SOI-type semiconductor device according to the present invention;
Figs. 39A through 39M are cross-sectional views for explaining the manufacturing steps of the device of Fig. 38;
Fig. 40 is a cross-sectional view illustrating a twenty fourth embodiment of the SOI-type semiconductor device according to the present invention; and
Figs. 41A through 41N are cross-sectional views for explaining the manufacturing steps of the device of Fig. 40.

### DESCRIPTION OF THE PREFERRED EMBODIMENTS

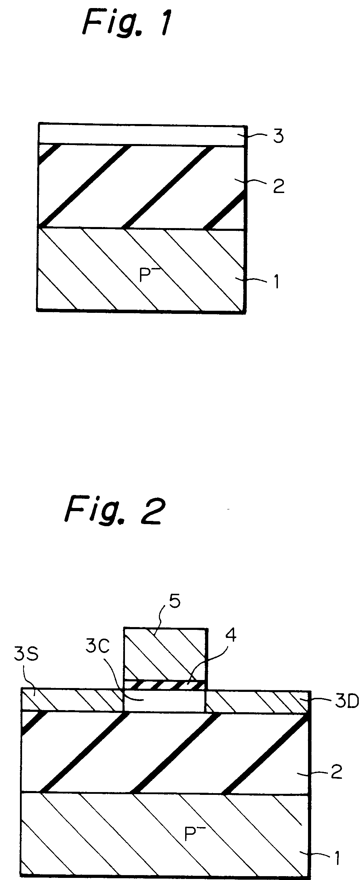

Before the description of the preferred embodiments, prior art SOI-type semiconductor devices will be explained with reference to Figs. 1, 2, 3A, 3B, 4A and 4B.

In Fig. 1, which illustrates a prior art SOI-type substrate, reference numeral 1 designates a P⁻-type monocrystalline silicon substrate having an impurity concentration of about 1×10¹⁵/cm³ on which a silicon oxide layer 2 is formed. Also, formed on the silicon oxide layer 2 is a monocrystalline silicon layer 3. In this case, the silicon oxide layer 2 is about 100 to 500 nm thick, and the monocrystalline silicon layer 3 is about 30 to 150 nm thick.

Transistor elements such as a MOS transistor are formed in the monocrystalline silicon layer 3 as illustrated in Fig. 2. That is, a source region 3S, a drain region 3D and a channel region 3C therebetween are formed in the monocrystalline silicon layer 3. In this case, the source regions 3S and 3D are of an N⁺-type. Also, a gate silicon oxide layer 4 is formed on the channel region 3C, and a gate electrode 5 made of N-type impurity doped polycrystalline silicon is formed on the gate silicon oxide layer 4.

In Fig. 2, the source region 3S and the drain region 3D reach the silicon oxide layer 2. Therefore, the p-n junction capacitance between the drain region and substrate of a conventional MOS transistor is replaced by the very small capacitance of the silicon oxide layer 2, thus increasing the operation speed simultaneously with reducing the power dissipation as compared with the conventional MOS transistor.

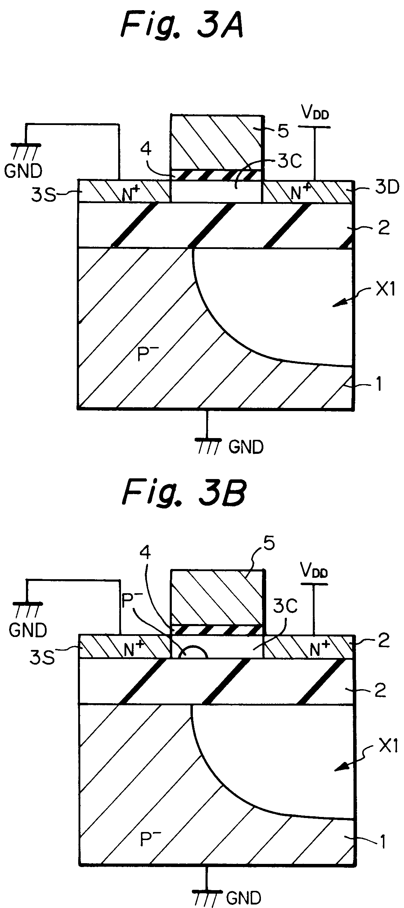

If the maximum thickness of a depletion region in the channel region 3C is larger than that of the monocrystalline silicon layer 3, the channel region 3C is fully depleted in an ON state as illustrated in Fig.3A, and accordingly, this SOI transistor is called a "fully-depleted SOI transistor". On the other hand, if the maximum thickness of a depletion region in the channel region 3C is smaller than that of the monocrystalline silicon layer 3, the channel region 3C is partially depleted, i.e., a P⁻-type neutral region is left in the channel region 3C in an ON state, and accordingly, this SOI transistor is called a "partially-depleted SOI transistor".

Note that a fully depleted SOI transistor having a thin monocrystalline silicon layer less than approximately 100 nm can effectively suppress the short channel effect (see: Y.Omura et al., "0.1- µm-gate, Ultrathin-Film CMOS Devices Using SIMOX Substrate with 80-nm-Thick Buried Oxide layer", Technical Digest of IEDM, pp.675-678, 1991). Also, the distribution of the depletion region X1 depends upon the thickness of the silicon oxide layer 2, the flat band voltage V_{FB}, the impurity concentration, and the power supply voltage V_{DD}. However, the thinner silicon oxide layer 2 and the lower impurity concentration of the silicon substrate 1 are required to obtain higher performance and higher operation speed of the transistor (see: the Y.Ohmura document).

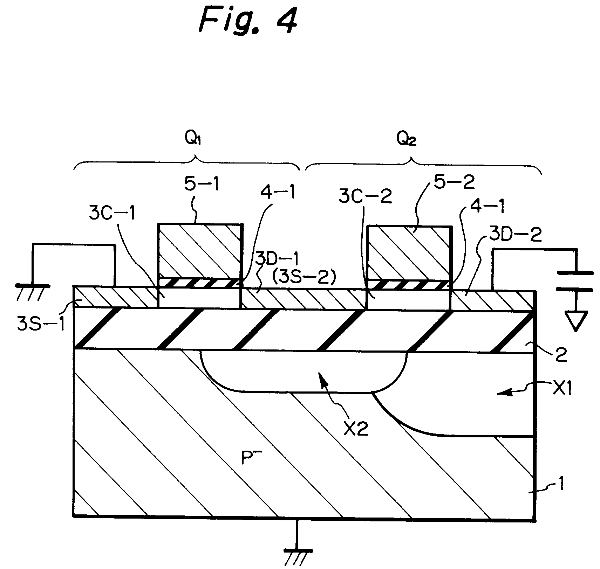

When a ground voltage GND is applied to the source region 3S and the substrate 1, and a power supply voltage V_{DD} such as 3V or 5V is applied to the drain region 3D, a depletion region as indicated by X1 in Figs. 3A and 3B is grown in the substrate 1 beneath the drain region D. In this case, the thickness of a depletion region in the semiconductor substrate 1 is dependent upon the impurity concentration thereof. In both the fully depleted and partially depleted SOI transistors, when the difference in potential between the drainregion 3D and the silicon substrate 1 is O V, the thickness of the depletion region X1 is minumum, i.e., the parasitic capacitance between the drain region 3D and the silicon substrate 1 is maximum. In this case, the maximum parasitic capacitance depends on the thickness of the silicon oxide layer 2. However, actually, as the power supply voltage V_{DD} is increased, the depletion region X1 is grown to reduce the parasitic capacitance between the drain region 3D and the silicon substrate 1. On the other hand, when the voltage at the gate electrode 5 is increased, a depletion region is grown in the channel region 3C, and finally reaches the silicon oxide layer 2. As a result, the total capacitance of the transistor is made up of a series of a gate capacitance, a capacitance of the depletion region of the channel region 3C, and a capacitance of the silicon oxide layer 2. Therefore, the threshold voltage of the transistor is strongly influenced by the potential of the silicon substrate 1 beneath the channel region 3C. For example, if this substrate potential is changed from O V to a negative voltage, the threshold voltage Vₜₕ of an N-channel MOS transistor is increased (see: Hyung-Kyu Lim et al., "Threshold voltage of Thin-film Silicon-on-Insulator (SOI) MOSFET's" , IEEE Trans. on Electron Devices, Vol.ED-30, No.10, pp.1244-1251, Oct. 1983), and the carrier mobiliby within the channel region 3C is reduced (see: Donald C. Mayer, "Mode of Operation and Radiation Sensitivity of Ultrathin SOI Transistors", IEEE Trans. on Electron Devices, Vol.37, No.5, pp.1280-1288, May 1990). Thus, when the depletion region X1 reaches beneath the channel region 3C in addition to a region beneath the drain region 3D, the threshold voltage Vₜₕ is reduced, and accordingly, the current drivability is reduced. In Figs. 4, which illustrates two MOS transistors Q₁ and Q₂ connected in series, when a high voltage is applied to both gate electrodes 5-1 and 5-2 of the transistors Q₁ and Q₂, the transistors Q₁ and Q₂ are turned ON. In this case, assume that the voltage at the drain region 3D-2 of the transistor Q₂, which is connected to a parasitic capacitor by a wiring (not shown), is high. As a result, a depletion region as indicated by X1 is grown in a similar way to that shown in Figs. 3A and 3B. Also, a source region 3S-2 of the transistor Q₂, i.e., a drain region 3D-1 of the transistor Q₁ is charged by a current flowing through the transistor Q₂, so that the voltage at the source region 3S-2 (the drain region 3D-1) is increased. Therefore, a depletion region is grown as indicated by X2. This depletion region X2 also reaches beneath the channel regions 3C-1 and 3C-2 of the transistors Q₁ and Q₂. Thus, the threshold voltages of both the transistors Q ₁ and Q₂ are reduced, and accordingly, the current drivability thereof is reduced.

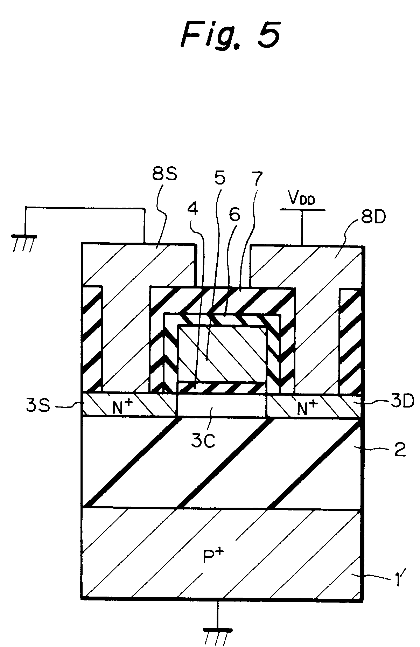

In Fig. 5, which illustrates a first embodiment of the present invention, a P⁺-type monocrystalline silicon substrate 1' having a high impurity concentration of more than 1×10¹⁹/cm³ is provided instead of the P⁻-type monocrystalline silicon substrate 1 of Fig. 2. In this case, the silicon oxide layer 2 is about 400 nm thick, and the monocrystalline silicon layer 3 is about 100 nm thick. Also, formed on the gate silicon layer 5 are a thermal silicon oxide layer 6 and a chemical vapor deposition (CVD) silicon oxide layer 7. The silicon oxide layers 6 and 7 are perforated, and then an aluminum layer is deposited and patterned to form aluminum wirings 8S and 8D.

In Fig. 5, since the impurity concentration of the silicon substrate 1' is high, even when the power supply voltage V_{DD} applied to the drain region 3D is increased, a depletion region is hardly grown within the silicon substrate 1′ beneath the channel region 3C.

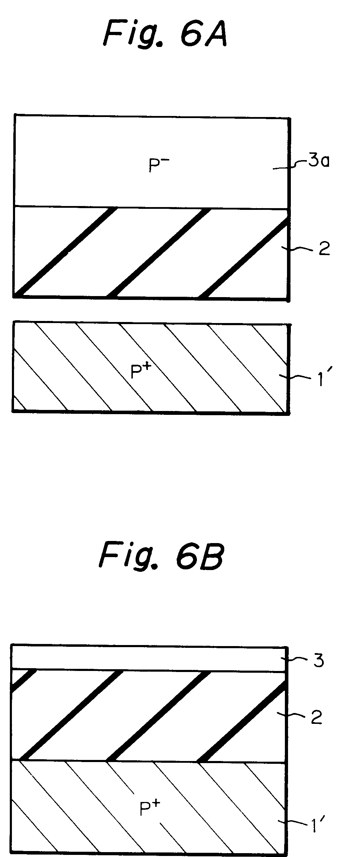

The manufacture of the device of Fig. 5 is explained next with reference to Figs. 6A through 6D.

First, referring to Fig. 6A, a silicon oxide layer 2 is formed by thermally oxidizing a impurity lightly doped monocrystalline silicon substrate 3a. On the other hand, an impurity highly doped monocrystalline silicon substrate 1' is prepared.

Next, referring to Fig. 6B, the silicon oxide layer 2 is adhered to the monocrystalline silicon substrate 1'. Then, the monocrystalline silicon substrate 3a is polished by a chemical mechanical polishing (CMP) or the like, to complete a thin monocrystalline silicon layer 3.

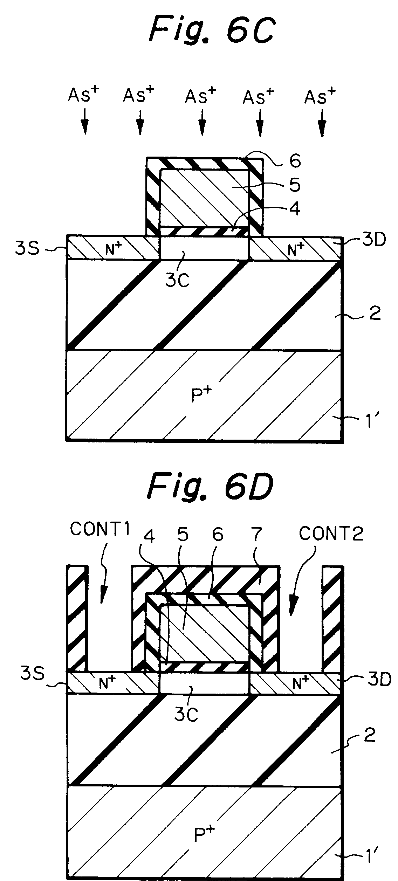

Next, referring to Fig. 6C, a gate silicon oxide layer 4 is formed by thermally oxidizing the silicon layer 3, and an N-type impurity doped polycrystalline silicon layer is formed on the entire surface. Then the polycrystalline silicon layer is patterned by a photolithography and dry etching process to form a gate electrode 5. Further, an about 50 nm thick silicon oxide layer 6 is formed by thermally oxidizing the gate electrode 5. Then, N-type impurities such as arsenic are ion-implanted with a mask of the gate electrode 5 into the silicon layer 3 to form a source region 3S and a drain region 3D. In this case, a region the silicon layer 3 sandwiched by the source region 3S and 3D is a channel region 3C.

Finally, referring to Fig. 6D, an about 500 nm thick silicon oxide layer 7 is formed by a CVD process, and contact holes CONT1 and CONT2 are perforated in the silicon oxide layer 7.

Then, an aluminum layer is deposited by a sputtering process and is patterned to form aluminum wirings 8S and 8D, thus completing the device of Fig. 5.

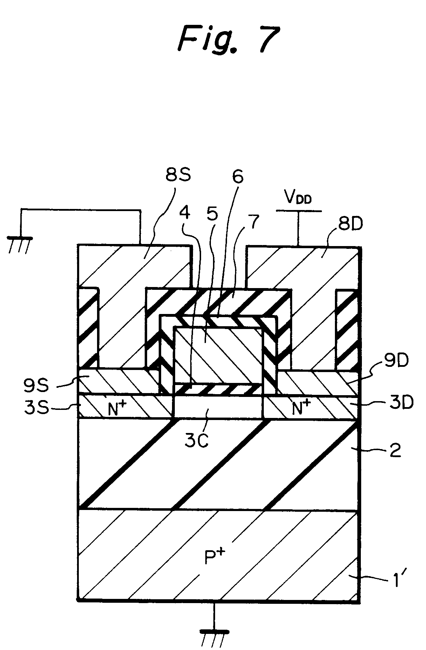

In Fig. 7, which illustrates a second embodiment of the present invention, monocrystalline silicon layers 9S and 9D are inserted between the aluminum wiring 8S and the source region 3S and between the aluminum wiring 8D and the drain region 3D of Fig. 5. Note that if the silicon layer 3 is made thinner, for example, about 50 nm thick, the parasitic resistance of the source and drain is remarkably increased to reduce the current drivability.

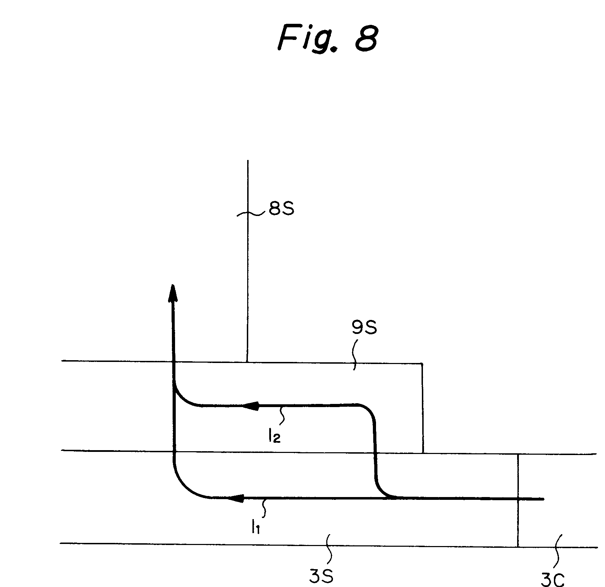

As shown in Fig. 8, the monocrystalline silicon layer 9S is provided, so that a current I₂ in addition to a current I₁ flows from the channel region 3C to the aluminum wiring 9D (9S). Therefore, the parasitic resistance of the source region 3S is reduced, and hence, the parasitic resistance of the source and drain is substantially reduced.

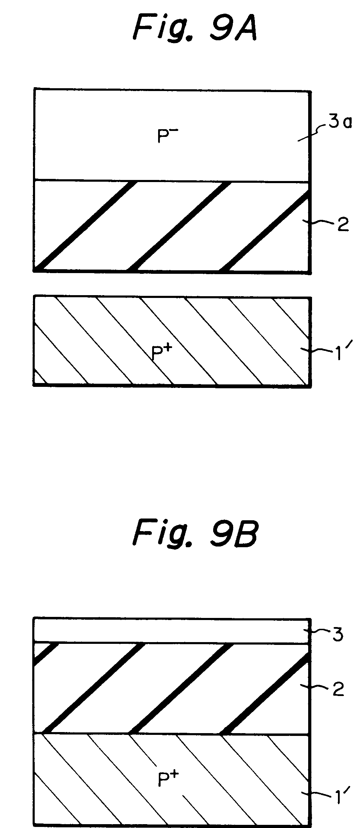

The manufacture of the device of Fig. 7 is explained next with reference to Figs. 9A through 9D.

First, referring ot Figs. 9A, in the same way as in to Fig. 6A, a silicon oxide layer 2 is formed by thermally oxidizing an impurity lightly doped silicon substrate 3a. On the other hand, an impurity highly doped monocrystalline silicon substrate 1' is prepared.

Next, referring to Fig. 9B, in the same way as in Fig. 6B, the silicon oxide layer 2 is adhered to the monocrystalline silicon substrate 1'. Then, the monocrystalline silicon substrate 3a is polished by a CMP process or the like, to complete a thin monocrystalline silicon layer 3.

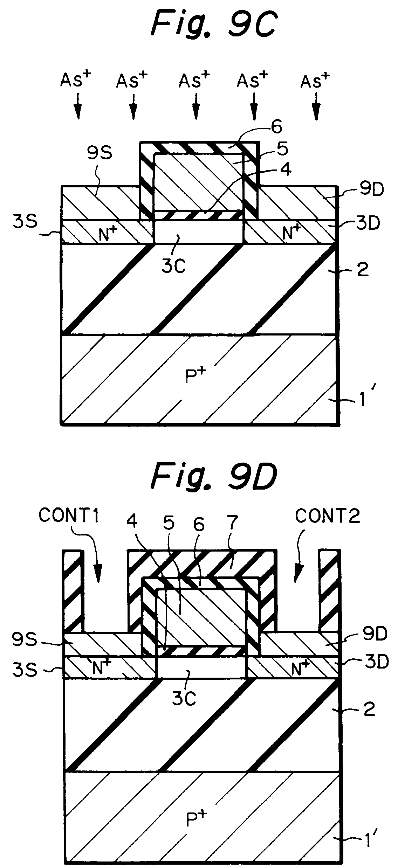

Next, referring to Fig. 9C, in a similar way to that shown in Fig. 6C, a gate silicon oxide layer 4 is formed by thermally oxidizing the silicon layer 3, and an N-type impurity doped polycrystalline silicon layer is formed on the entire surface. Then, the silicon oxide layer is patterned by a photolithography and dry etching process to form a gate electrode 5. Further, an about 50 nm thick silicon oxide layer 6 is formed by thermally oxidizing the gate electrode 5. In this case, only the silicon oride layer on the source region 35 and the drain region 3D is removed. Then, about 100 nm thick monocrystalline silicon layers 9S and 9D are grown by a selective epitaxial growth technology. Then, N-type impurities such as arsenic are ion-implanted with a mask of the gate electrode 5 into the silicon layer 3 to form a source region 3S and a drain region 3D. In this case, a region of the silicon layer 3 sandwiched by the source region 3S and the drain region 3D is a channel region 3C.

Finally, referring to Fig. 9D, in the same way as shown in Fig. 6D, an about 500 nm thick silicon oxide layer 7 is formed by a CVD process, and contact holes CONT1 and CONT2 are perforated in the silicon oxide layer 7.

Then, an aluminum layer is deposited by a sputtering process and is patterned to form aluminum wirings 8S and 8D, thus completing the device of Fig. 7.

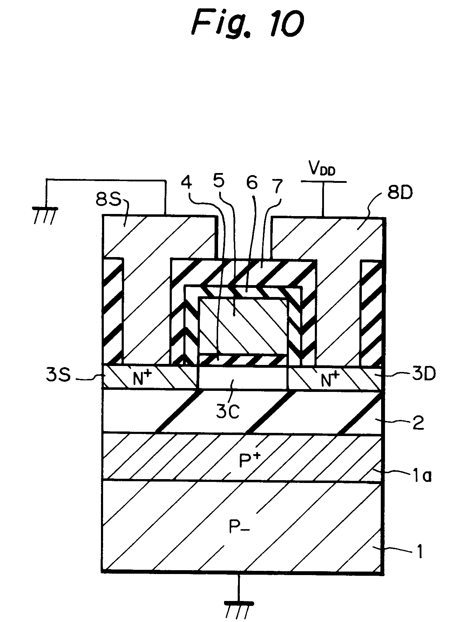

In Fig. 10, which illustrates a third embodiment of the present invention, an impurity lightly doped monocrystalline silicon substrate 1 and an about 500 nm thick highly doped monocrystalline silicon layer la are provided instead of the P⁺-type monocrystalline silicon substrate 1' of Fig. 5. In this case, the silicon substrate 1 has an impurity concentration of about 1×10¹⁵/cm³, while the silicon layer 1a has an impurity concentration higher than 1×10¹⁹/cm³. Also, the silicon oxide layer 2 is about 100 nm thick, and the monocrystalline silicon layer 3 is about 50 nm thick.

Also in Fig. 10, since the impurity concentration of the silicon layer la is high, even when the power supply voltage V_{DD} applied to the drain region 3D is increased, a depletion region is hardly grown within the silicon substrate 1 beneath the drain region 3D.

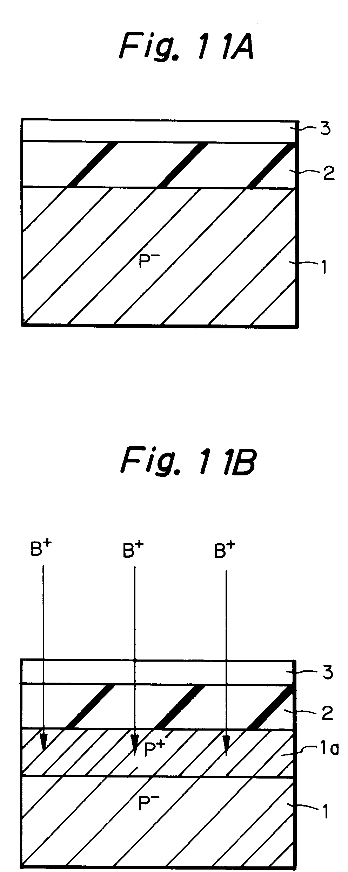

The manufacture of the device of Fig. 10 is explained next with reference to Figs. 11A through 11D.

First, referring to Fig. 11A, a SOI substrate formed by an impurity lightly doped P-type monocrystalline silicon substrate 1, a silicon oxide layer 2 and an impurity lightly doped silicon layer 3 is prepared. For example, about 4×10¹⁷ oxygen ions/cm are implanted at an acceleration energy of about 180 keV into an impurity lightly-doped P-type (100) monocrystalline silicon substrate whose temperature is about 550°C, and thereafter, a heat operation at about 1350°C is performed thereupon for about six hours. Thus, the SOI substrate of Fig. 11A is obtained.

Next, referring to Fig. 11B, P-type impurities such as boron are ion-implanted into the P⁻-type silicon substrate 1, to create a impurity highly doped monocrystalline silicon layer 1a in the P⁻-type monocrystalline silicon substrate 1. In this case, the acceleration energy of the P-type impurities is determined in view of the thickness of the monocrystalline silicon layer 3 and the silicon oxide layer 2.

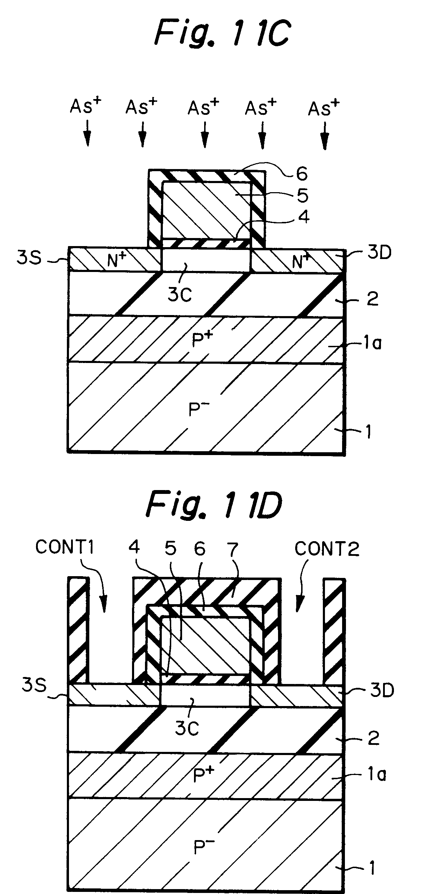

Next, referring to Fig. 11C, in the same way as in Fig. 6C, a gate silicon oxide layer 4 is formed by thermally oxidizing the silicon layer 3, and an N-type impurity doped polycrystalline silicon layer is formed on the entire surface. Then, the polycrystalline silicon layer is patterned by a photolithography and dry etching process to form a gate electrode 5. Further, an about 50 nm thick silicon oxide layer 6 is formed by thermally oxidizing the gate electrode 5. Then, N-type impurities such as arsenic are ion-implanted with a mask of the gate electrode 5 into the silicon layer 3 to form a source region 3S and a drain region 3D. In this case, a region of the silicon layer 3 sandwiched by the source region 3S and the drain region 3D is a channel region 3C.

Finally, referring to Fig. 11D, in the same way as shown in Fig. 6D, an about 500 nm thick silicon oxide layer 7 is formed by a CVD process, and contact holes CONT1 and CONT2 are perforated in the in the silicon oxide layer 7.

Then, an aluminum layer is deposited by a sputtering process and is patterned to form aluminum wirings 8S and 8D, thus completing the device of Fig. 10.

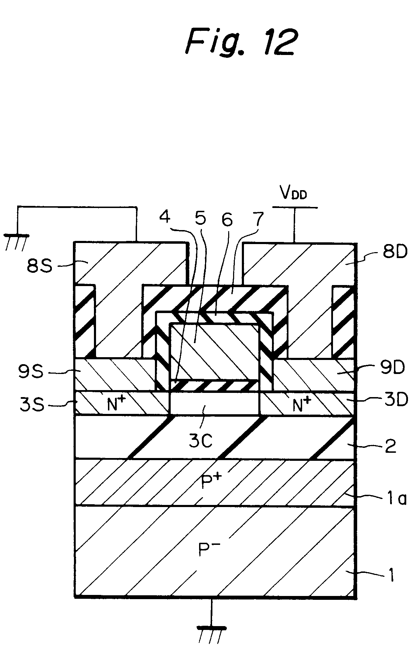

In Fig. 12, which illustrates a fourth embodiment of the present invention, monocrystalline silicon layers 9S and 9D are inserted between the aluminum wiring 3S and the source region 3S and between the aluminum wiring 8D and the drain region 3D of Fig. 10. Thus, the parasitic resistance of the source and drain is remarkably decreased to increase the current drivability.

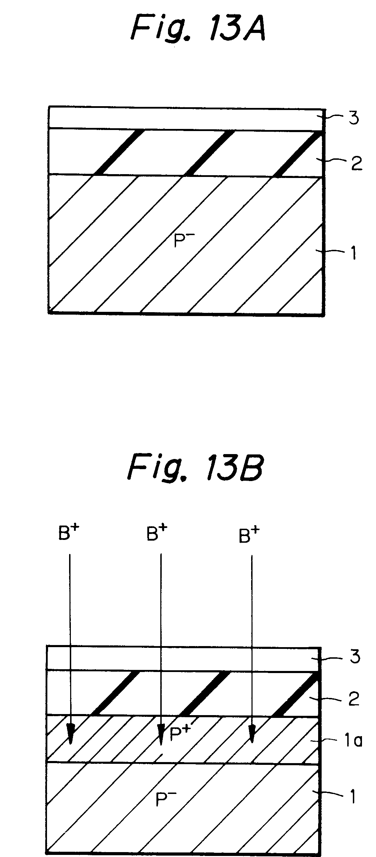

The manufacture of the device of Fig. 12 is explained next with reference to Figs. 13A through 13D.

First, referring to Fig. 13A, in the same way as shown in Fig. 11A, a SOI substrate formed by an impurity lightly doped P-type monocrystalline silicon substrate 1, a silicon oxide layer 2 and an about 500 nm thick impurity lightly doped silicon layer 3 is prepared. For example, about 4×10¹⁷ oxygen ions/cm are implanted at an acceleration energy of about 180 keV into an impurity lightly-doped P-type (100) monocrystalline silicon substrate whose temperature is about 550°C, and thereafter, a heat operation at about 1350°C is performed thereupon for about six hours. Thus, the SOI substrate of Fig. 11A is obtained.

Next, referring to Fig. 13B, in the same way as shown in Fig. 11B, P-type impurities such as boron are ion-implanted into the P⁻-type silicon substrate 1, to create a impurity highly doped monocrystalline silicon layer la in the P⁻-type monocrystalline silicon substrate 1. In this case, the acceleration energy of the P-type impurities is determined in view of the thickness of the monocrystalline silicon layer 3 and the silicon oxide layer 2.

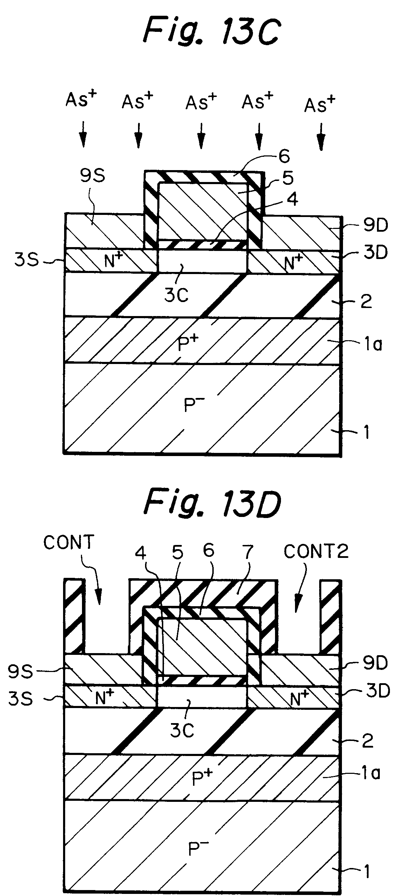

Next, referring to Fig. 13C, in a similar way to that shown in Fig. 11C, a gate silicon oxide layer 4 is formed by thermally oxidizing the silicon layer 3, and an N-type impurity doped polycrystalline silicon layer is formed on the entire surface. Then, the polycrystalline silicon layer is patterned by a photolithography and dry etching process to form a gate electrode 5. Further, an about 50 nm thick silicon oxide layer 6 is formed by thermally oxidizing the gate electrode 5. In this case, only the silicon oxide layer on the source region 3S and the drain region 3D are removed. Then, about 100 nm thick monocrystalline silicon layers 9S and 9D are grown by a selective epitaxial growth technology. Then, N-type impurities such as arsenic are ion-implanted with a mask of the gate electrode 5 into the silicon layer 3 to form a source region 3S and a drain region 3D. In this case, a region of the silicon layer 3 sandwiched by the source region 3S and the drain region 3D is a channel region 3C.

Finally, referring to Fig. 13D, in the same way as shown in Fig. 11D, an about 500 nm thick silicon oxide layer 7 is formed by a CVD process, and contact holes CONT1 and CONT2 are perforated in the silicon oxide layer 7.

Then, an aluminum layer is deposited by a sputtering process and is patterned to form aluminum wirings 8S and 8D, thus completing the device of Fig. 12.

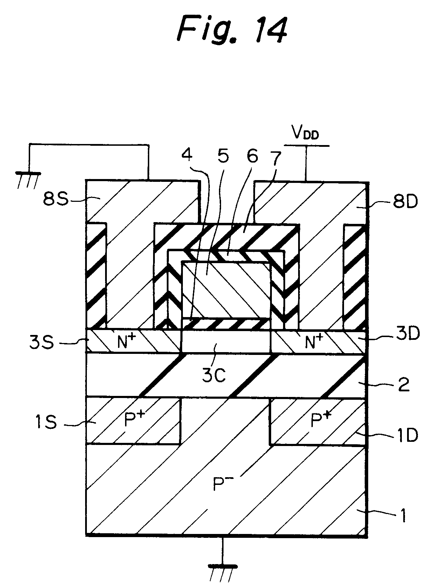

In Fig. 14, which illustrates a fifth embodiment of the present invention, impurity highly doped regions 1S and 1D beneath the source region 3S and the drain region 3D, respectively, are provided instead of the impurity highly doped region 1a of Fig. 10. In this case, the impurity highly doped regions 1S and 1D are about 500 nm thick and have an impurity concentration of more than 1×10¹⁹/ cm³.

Also in Fig. 14, since the impurity concentration of the impurity doped region 1D is high, even when the power supply voltage V_{DD} applied to the drain region 3D is increased, a depletion region is hardly grown in the silicon substrate 1 beneath the channel region 3C.

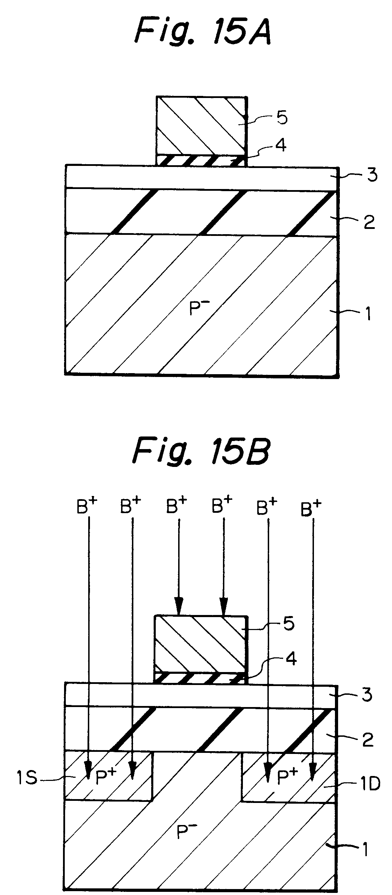

The manufacture of the device of Fig. 14 is explained next with reference to Figs. 15A through 15D.

First, referring to Fig. 15A, a SOI substrate formed by an impurity lightly doped P-type monocrystalline silicon substrate 1, a silicon oxide layer 2 and an impurity lightly doped silicon layer 3 is prepared. For example, about 4×10¹⁷ oxygen ions/cm are implanted at an acceleration energy of about 180 keV into an impurity lightly-doped P-type (100) monocrystalline silicon substrate whose temperature is about 550°C, and thereafter, a heat operation at about 1350°C is performed thereupon for about six hours. Thus, the SOI substrate of Fig. 15A is obtained.

Next, a gate silicon oxide layer 4 is formed by thermally oxidizing the silicon layer 3, and an N-type impurity doped polycrystalline silicon layer is formed on the entire surface. Then, the polycrystalline silicon layer is patterned by a photolithography and dry etching process to form a gate electrode 5. Next, about 3×10¹⁵ P-type impurities such as boron/cm are ion-implanted at an acceleration energy of about 80 to 100 keV into the P--type silicon substrate 1 with a mask of the gate electrode 5, to thereby form P⁺-type impurity regions 1S and 1D.

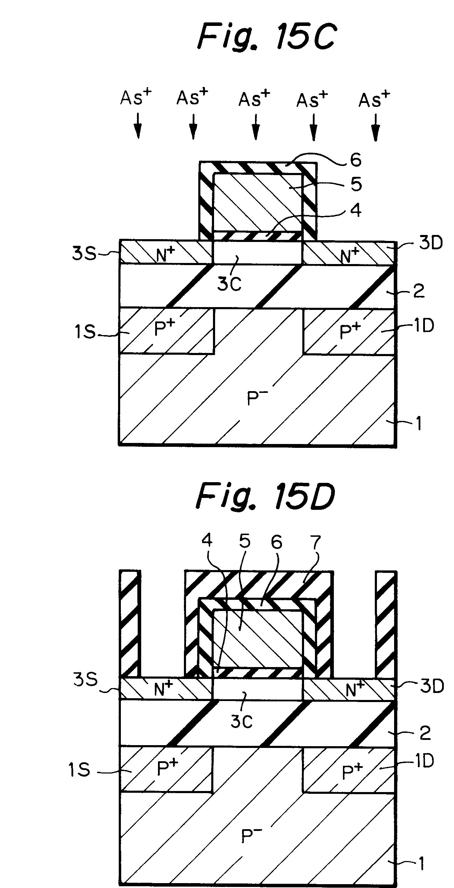

Next, referring to Fig. 15C, in the same way as shown in Fig. 11C, an about 50 nm thick silicon oxide layer 6 is formed by thermally oxidizing the gate electrode 5. Then, N-type impurities such as arsenic are ion-implanted with a mask of the gate electrode 5 into the silicon layer 3 to form a source region 3S and a drain region 3D. In this case, a region of the silicon layer 3 sandwiched by the source region 3S and the drain region 3D is a channel region 3C.

Finally, referring to Fig. 15D, in the same way as shown in Fig. 11D, an about 500 nm thick silicon oxide layer 7 is formed by a CVD process, and contact holes CONT1 and CONT2 are perforated in the silicon oxide layer 7.

Then, an aluminum layer is deposited by a sputtering process and is patterned to form aluminum wirings 8S and 8D, thus completing the device of Fig. 14.

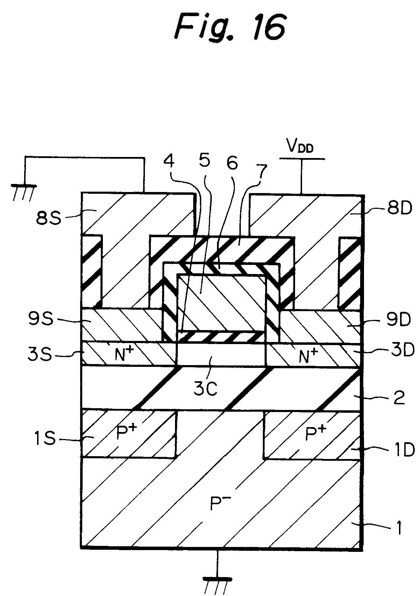

In Fig. 16, which illustrates a sixth embodiment of the present invention, monocrystalline silicon layers 9S and 9D are inserted between the aluminum wiring 8S and the source region 3S and between the aluminum wiring 8D and the drain region 3D of Fig. 14. Thus, the parasitic resistance of the source and drain is remarkably decreased to increase the current drivability.

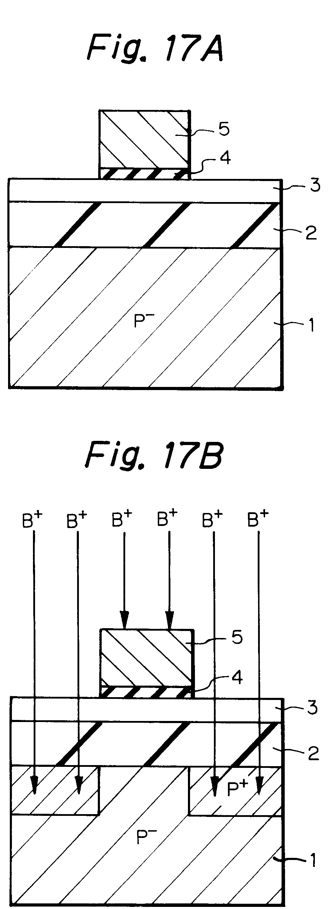

The manufacture of the device of Fig. 16 is explained next with reference to Figs. 17A through 17D.

First, referring to Fig. 17A, in the same way as shown in Fig. 15A, a SOI substrate formed by an impurity lightly doped P-type monocrystalline silicon substrate 1, a silicon oxide layer 2 and an impurity lightly doped silicon layer 3 is prepared. For example, about 4×10¹⁷ oxygen ions/cm are implanted at an acceleration energy of about 180 keV into an impurity lightly-doped P-type (100) monocrystalline silicon substrate whose temperature is about 550°C, and thereafter, a heat operation at about 1350°C is performed thereupon for about six hours. Thus, the SOI substrate of Fig. 11A is obtained.

Next, a gate silicon oxide layer 4 is formed by thermally oxidizing the silicon layer 3, and an N-type impurity doped polycrystalline silicon layer is formed on the entire surface. Then, the polycrystalline silicon layer is patterned by a photolithography and dry etching process to form a gate electrode 5. Next, about 3×10¹⁵ P-type impurities such as boron/cm are ion-implanted at an acceleration energy of about 80 to 100 keV into the P⁻ -type silicon substrate 1 with a mask of the gate electrode 5, to thereby form a P⁺-type impurity regions 1S and 1D.

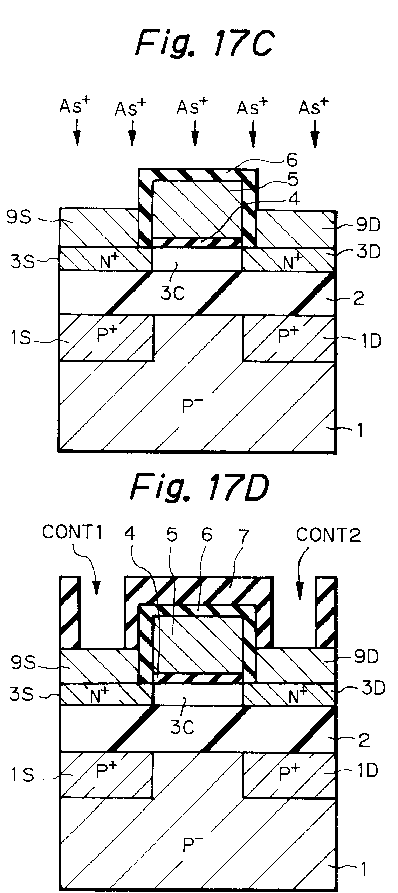

Next, referring to Fig. 17C, in a similar way to shown in Fig. 15C, an about 50 nm thick silicon oxide layer 6 is formed by thermally oxidizing the gate electrode 5. In this case, only the silicon oxidelayer on the source region 3S and the drain region 3D is removed. Then, about 100 nm thick monocrystalline silicon layers 9S and 9D are grown by a selective epitaxial growth technology. Then, N-type impurities such as arsenic are ion-implanted with a mask of the gate electrode 5 into the silicon layer 3 to form a source region 3S and a drain region 3D. In this case, a region of the silicon layer 3 sandwiched by the source region 3S and the drain region 3D is a channel region 3C.

Finally, referring to Fig. 17D, in the same way as shown in Fig. 15D, an about 500 nm thick silicon oxide layer 7 is formed by a CVD process, and contact holes CONT1 and CONT2 are perforated in the in the silicon oxide layer 7.

Then, an aluminum layer is deposited by a sputtering process and is patterned to form aluminum wirings 8S and 8D, thus completing the device of Fig. 16.

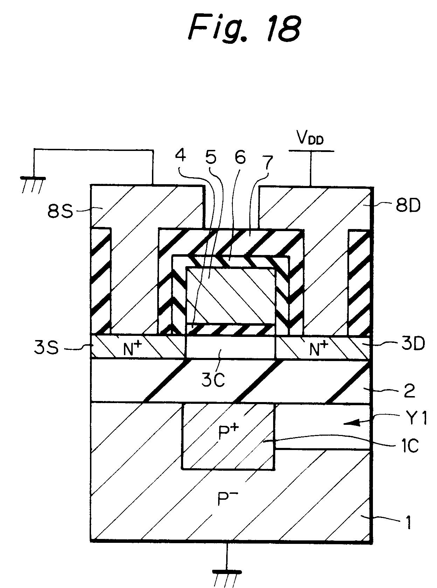

In Fig. 18, which illustrates a seventh embodiment of the present invention, an impurity highly doped region 1C beneath the channel region 3C is provided instead of the impurity highly doped region 1a of Fig. 10. In this case, the impurity highly doped region is about 500 nm thick and 1C has an impurity concentration higher than 1×10¹⁹/cm³. Also in Fig. 18, since the impurity concentration of the impurity doped region 1C is high, even when the power supply voltage V_{DD} applied to the drain region 3D is increased, so that although a depletion region is grown as indicated by Y1, such a depletion region is hardly grown in the silicon substrate 1 beneath the channel region 3C.

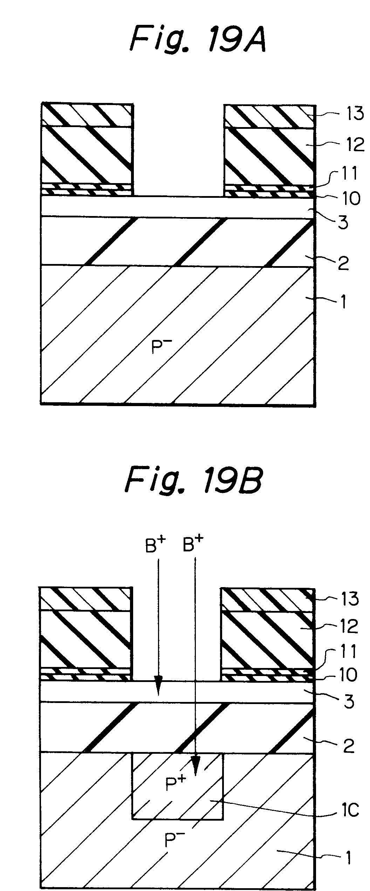

The manufacture of the device of Fig. 18 is explained next with reference to Figs. 19A through 19F.

First, referring to Fig. 19A, a SOI substrate formed by an impurity lightly doped P-type monocrystalline silicon substrate 1, a silicon oxide layer 2 and an impurity lightly doped silicon layer 3 is prepared. For example, about 4×10¹⁷ oxygen ions/cm are implanted at an acceleration energy of about 180 keV into an impurity lightly-doped P-type (100) monocrystalline silicon substrate whose temperature is about 550°C, and thereafter, a heat operation at about 1350°C is performed thereupon for about six hours. Thus, the SOI substrate of Fig. 11A is obtained.

Next, an about 10 nm thick silicon oxide layer 10 is formed by thermally oxidizing the silicon layer 3, an about 10 nm thick silicon nitride layer 11 is deposited by a CVD process, and an about 300 nm thick silicon oxide layer 12 is deposited by a CVD process. Then, a photoresist pattern 13 is coated thereon. Then, the silicon oxide layer 12, the silicon nitride layer 11 and the silicon oxide layer 10 are removed with a mask of the photoresist pattern 13 by a photolithography and dry etching process, to expose the silicon layer 3.

Next, referring to Fig. 19B, P-type impurities such as boron are ion-implated at different acceleration energies into the silicon layer 3 and the silicon substrate 1 with a mask of the photoresist pattern 13 and the silicon oxide layer 12. For the silicon layer 3, the acceleration energy of the impurity ions is relatively small to adjust the threshold voltage of the transistor. On the other hand, for the silicon substrate 1, the acceleration energy of the impurity ions is relatively large to form a P⁺-type impurity region 1C. Then, the photoresist pattern 13 is removed.

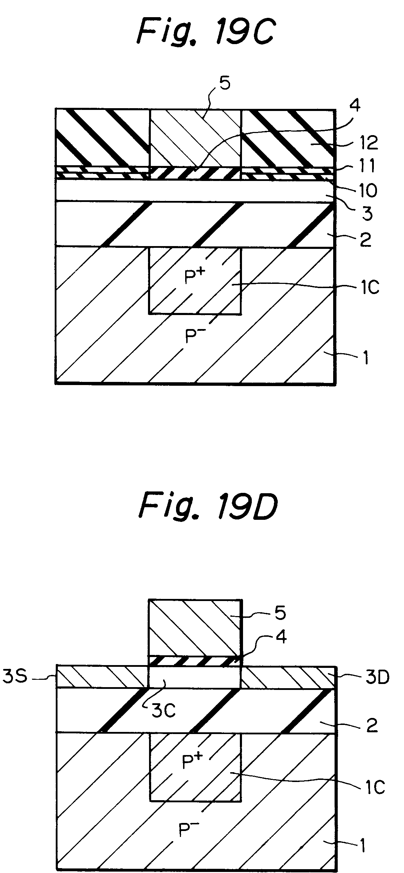

Next, referring to Fig. 19C, an about 10 nm thick gate silicon oxide layer 4 is formed by thermally oxidizing the silicon layer 3. Subsequently, an N-type impurity doped polycrystalline silicon layer is formed on the entire surface. Then, the polycrystalline silicon layer is patterned by a photolithography and dry etching process to form a gate electrode 5.

Next, referring to Fig. 19D, the silicon oxide layer 12 is removed by diluted fluoric acid, and the silicon nitride layer 11 is removed by hot phosphoric acid.

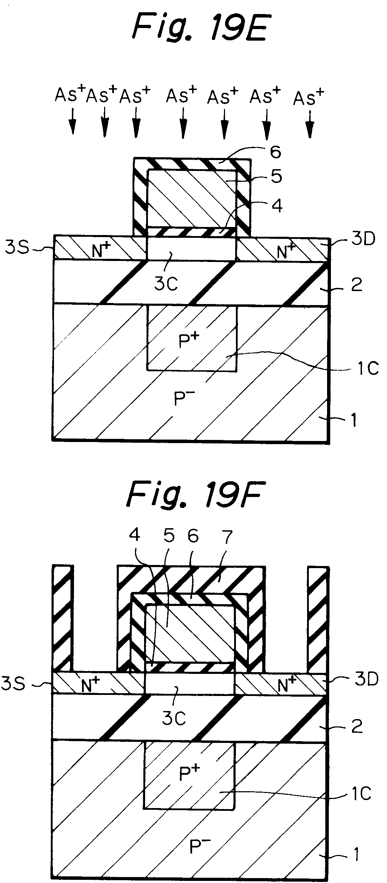

Next, referring to Fig. 19E, in the same way as in Fig. 15C, an about 50 nm thick silicon oxide layer 6 is formed by thermally oxidizing the gate electrode 5. Then N-type impurities such as arsenic are ion-implanted with a mask of the gate electrode 5 into the silicon layer 3 to form a source region 3S and a drain region 3D. In this case, a region of the silicon layer 3 sandwiched by the source region 3S and the drain region 3D is a channel region 3C.

Finally, referring to Fig. 19F, in the same way as shown in Fig. 15D, an about 500 nm thick silicon oxide layer 7 is formed by a CVD process, and contact holes CONT1 and CONT2 are perforated in the silicon oxide layer 7.

Then, an aluminum layer is deposited by a sputtering process and is patterned to form aluminum wirings 8S and 8D, thus completing the device of Fig. 18.

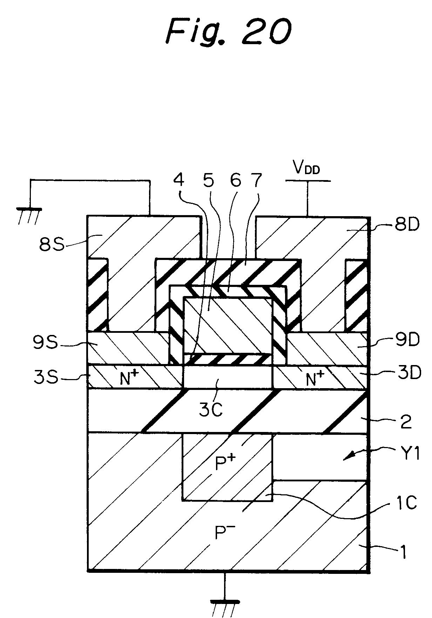

In Fig. 20, which illustrates an eighth embodiment of the present invention, monocrystalline silicon layers 9S and 9D are inserted between the aluminum wiring 8S and the source region 3S and between the aluminum wiring 8D and the drain region 3D of Fig. 18. Thus, the parasitic resistance of the source and drain is remarkably decreased to increase the current drivability.

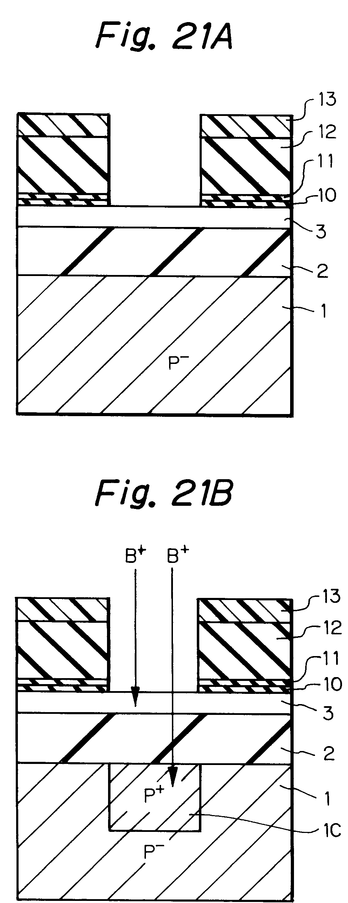

The manufacture of the device of Fig. 20 is explained next with reference to Figs. 21A through 21F.

First, referring to Fig. 21A, in the same way as in Fig. 19A, an SOI substrate formed by an impurity lightly doped P-type monocrystalline silicon substrate 1, a silicon oxide layer 2 and an impurity lightly doped silicon layer 3 is prepared. For example, about 4×10¹⁷ oxygen ions/cm are implanted at an acceleration energy of about 180 keV into an impurity lightly-doped P-type (100) monocrystalline silicon substrate whose temperature is about 550°C, and thereafter, a heat operation at about 1350°C is performed thereupon for about six hours. Thus, the SOI substrate of Fig. 11A is obtained.

Next, an about 10 nm thick silicon oxide layer 10 is formed by thermally oxidizing the silicon layer 3, an about 10 nm thick silicon nitride layer 11 is deposited by a CVD process, and an about 300 nm thick silicon oxide layer 12 is deposited by a CVD process. Then, a photoresist pattern 13 is coated thereon. Then, the silicon oxide layer 12, the silicon nitride layer 11 and the silicon oxide layer 10 are removed with a mask of the photoresist pattern 13 by a photolithography and dry etching process, to expose the silicon layer 3.

Next, referring to Fig. 21B, in the same way as in Fig. 19B, P-type impurities such as boron are ion-implated at different acceleration energies into the silicon layer 3 and the silicon substrate 1 with a mask of the photoresist pattern 13 and the silicon oxide layer 12. For the silicon layer 3, the acceleration energy of the impurity ions is relatively small to adjust the threshold voltage of the transistor. On the other hand, for the silicon substrate 1, the acceleration energy of the impurity ions is relatively large to form a P⁺-type impurity region 1C. Then, the photoresist pattern 13 is removed.

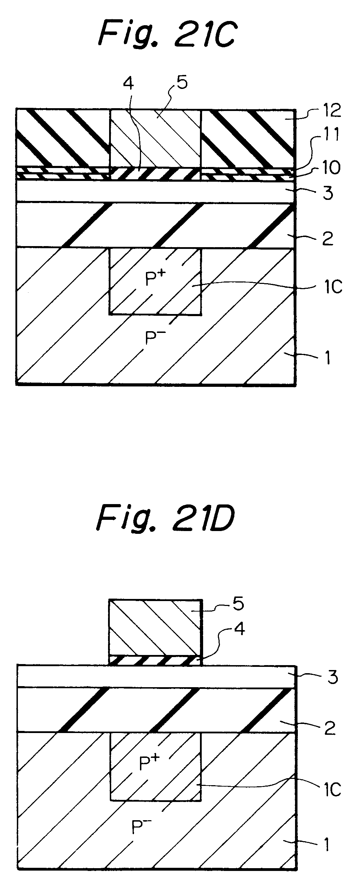

Next, referring to Fig. 21C, in the same way as in Fig. 19C, an about 10 nm thick gate silicon oxide layer 4 is formed by thermally oxidizing the silicon layer 3. Subsequently, an N-type impurity doped polycrystalline silicon layer is formed on the entire surface. Then, the polycrystalline silicon layer is patterned by a photolithography and dry etching process to form a gate electrode 5.

Next, referring to Fig. 21D, in the same way as in Fig. 19D, the silicon oxide layer 12 is removed by diluted fluoric acid, and the silicon nitride layer 11 is removed by hot phosphoric acid.

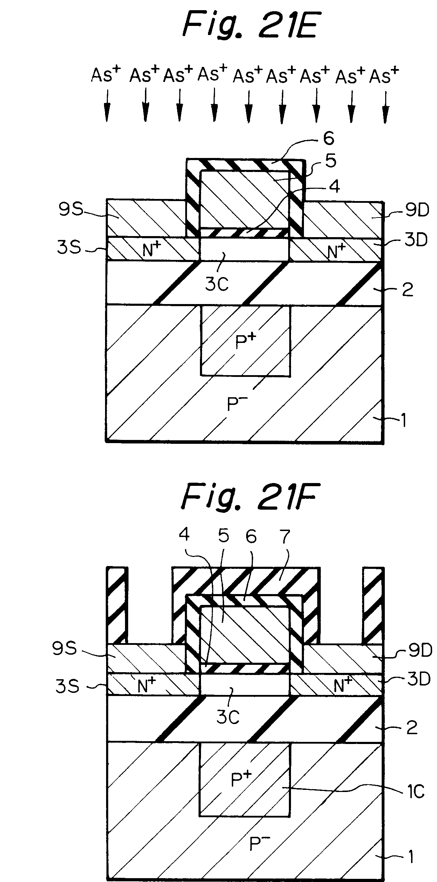

Next, referring to Fig. 21E, in a similar way as in Fig. 19E, an about 50 nm thick silicon oxide layer 6 is formed by thermally oxidizing the gate electrode 5. In this case, only the silicon oxide layer on the source region 3S and the drain region 3D are removed. Then, about 100 nm thick monocrystalline silicon layers 9S and 9D are grown by a selective epitaxial growth technology. Then, N-type impurities such as arsenic are ion-implanted with a mask of the gate electrode 5 into the silicon layer 3 to form a source region 3S and a drain region 3D. In this case, a region of the silicon layer 3 sandwiched by the source region 3S and the train region 3D is a channel region 3C.

Finally, referring to Fig. 21F, in the same way as shown in Fig. 19F, an about 500 nm thick silicon oxide layer 7 is formed by a CVD process, and contact holes CONT1 and CONT2 are perforated in the in the silicon oxide layer 7.

Then, an aluminum layer is deposited by a sputtering process and is patterned to form aluminum wirings 8S and 8D, thus completing the device of Fig. 20.

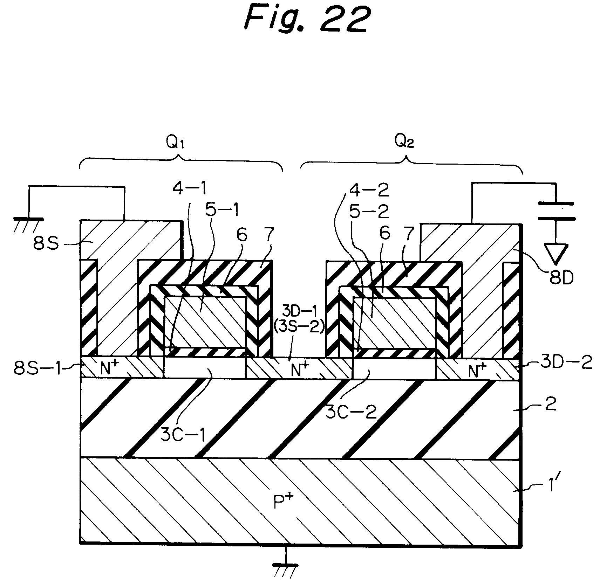

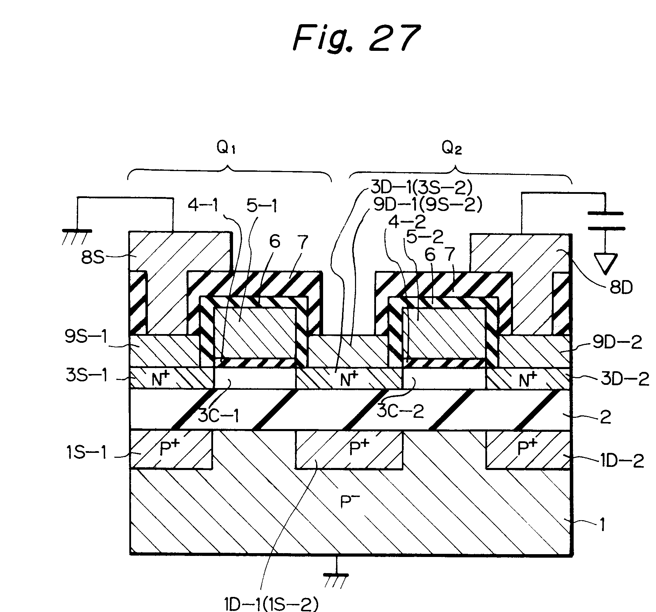

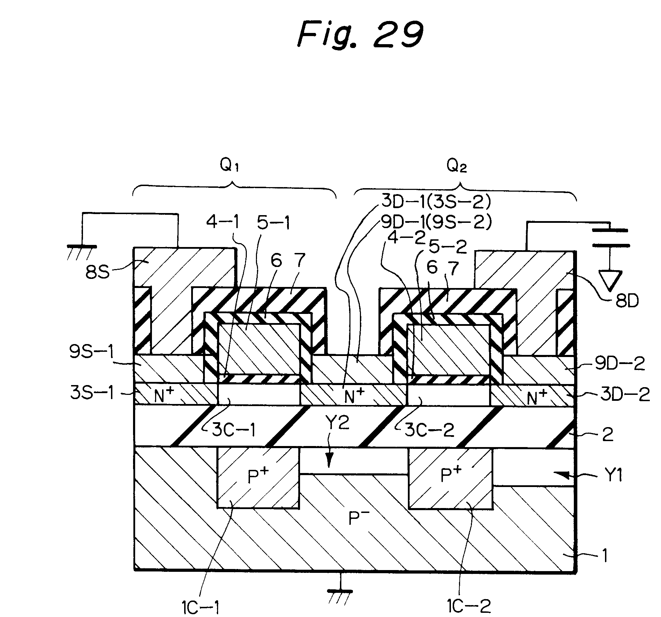

Figs. 22 through 29 are cross-sectional views illustrating ninth, tenth, eleventh, twelfth, thirteenth, fourteenth, fifteenth and sixteenth embodiments, vespectively, of the SOI-type semiconductor device according to the present invention, and correspond to the first, second, third, fourth, fifth, sixth, seventh and eighth embodiments, respectively, of the present invention. In Figs. 22 through 29, two N-channel MOS transistors Q₁ and Q₂ are connected in series, and also in this case, a depletion region is hardly grown in the silicon substrate 1 (1') beneath the channel regions 3C-1 and 3C-2, in the same way as in the first through eighth embodiments.

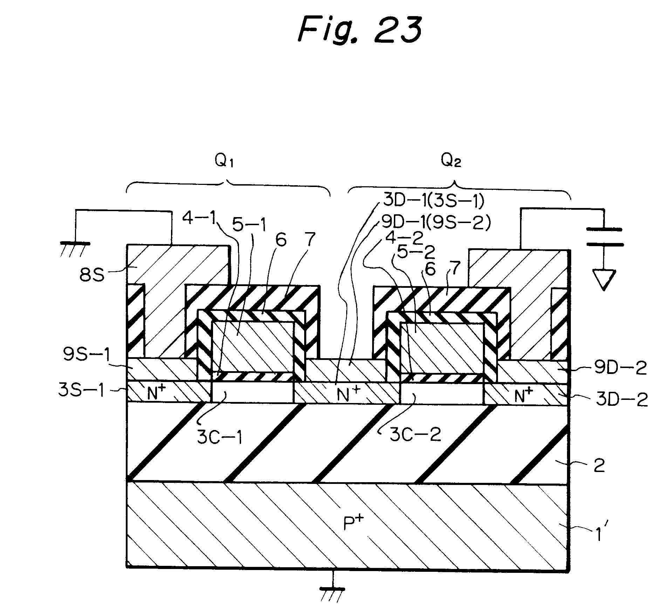

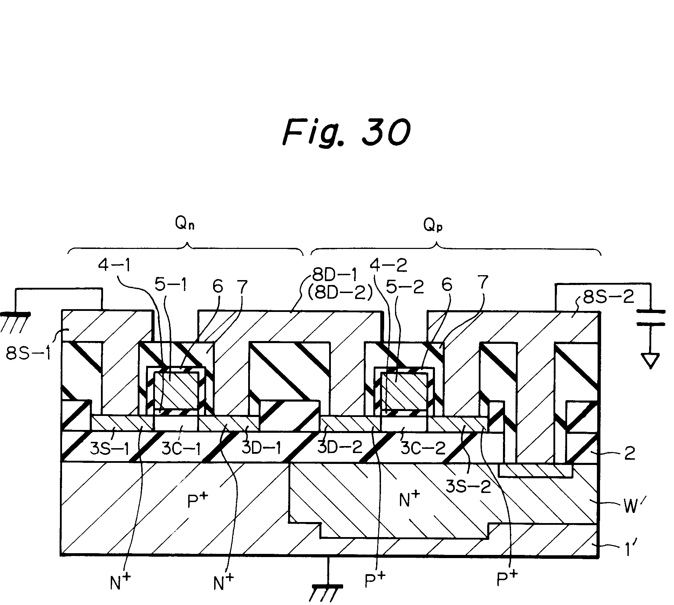

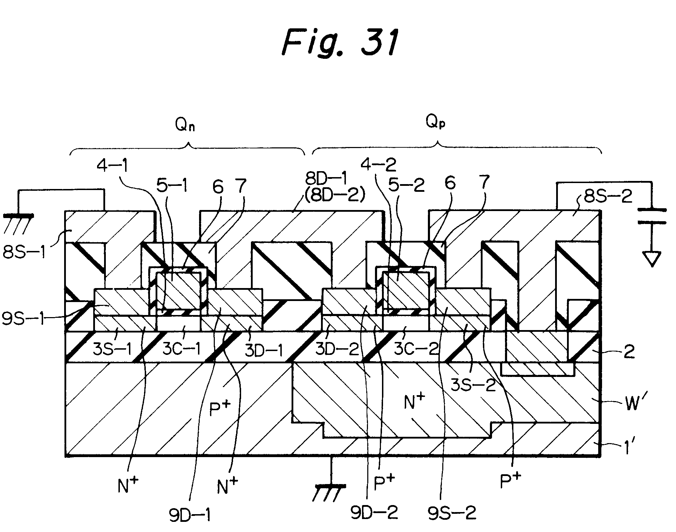

In Figs. 30 and 31, which illustrate seventeenth and eighteenth embodiments, respectively, of the present invention, the ninth and tenth embodiments as illustrated in Figs. 22 and 23 are applied to a CMOS circuit formed by a P-channel transistor Qₚ and an N-channel transistor Qₙ. That is, formed within a P⁺-type monocrystalline silicon substrate 1' is an N⁺-type well region W' which has an impurity concentration of more than 1×10¹⁹/ cm³. Also, the P⁺-type monocrystalline silicon substrate 1' is grounded, while the N⁺-type well region W' is connected to a source region 3S-2 of the transistor Qₚ. Thus, in Figs. 30 and 31, since the impurity concentration of the monocrystalline silicon substrate 1' for the N-channel transistor Qₙ and the impurity concentration of the N⁺-type well region W' are both high, even when the voltage applied to the source region 3S-2 is increased, a depletion region is hardly generated in the silicon substrate 1' beneath the channel region 3C-1 of the N-channel transistor Qₙ and in the N⁺-type well region W' beneath the channel region 3C-2 of the P-channel transistor Qₚ.

The CMOS device of Fig. 30 can be manufactured by the steps as illustrated in Figs. 6A to 6D in combination with a conventional CMOS manufacturing process. Also, the CMOS device of Fig. 31 can be manufactured by the steps as illustrated in Figs. 8A to 8D in combination with a conventional CMOS manufacturing process.

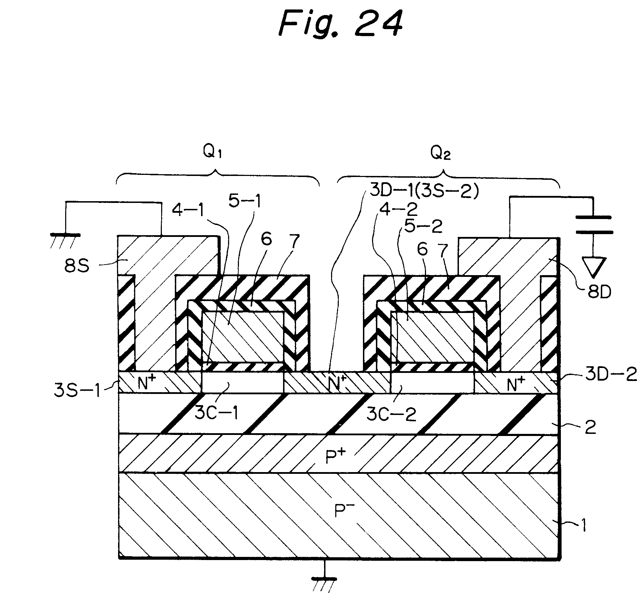

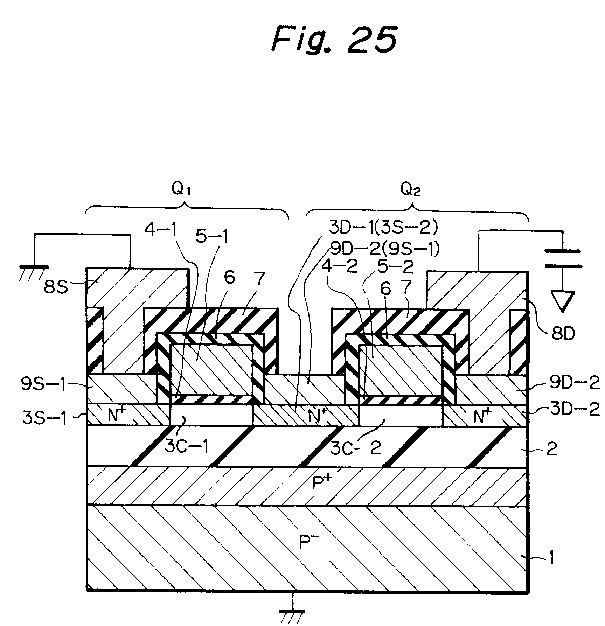

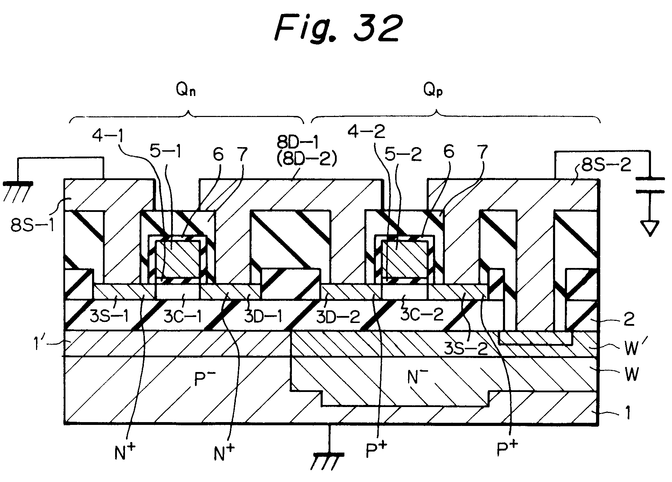

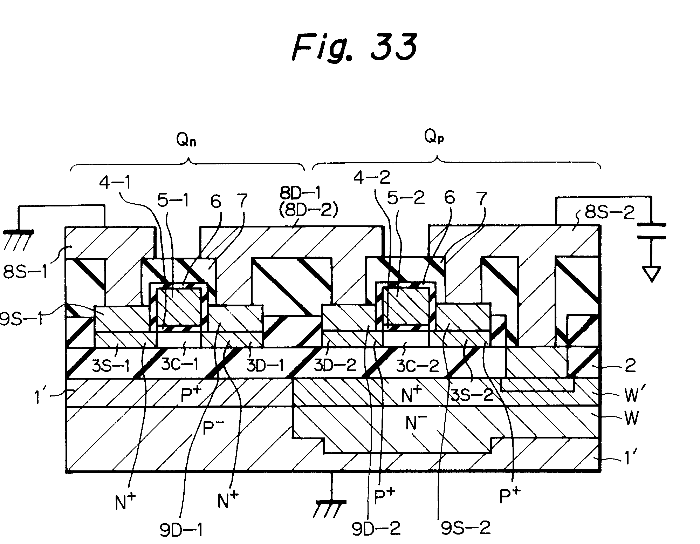

In Figs. 32 and 33, which illustrate nineteenth and twentieth embodiments, respectively, of the present invention, the eleventh and twelfth embodiments as illustrated in Figs. 24 and 25 are applied to a CMOS circuit formed by a P-channel transistor Qₚ and an N-channel transistor Qₙ. That is, formed within a P⁻-type monocrystalline silicon substrate 1 is an N⁻-type well region W which has an impurity concentration of about 1×10¹⁵/cm³. Also, a P⁺-type impurity region 1' having an impurity concentration of more than 1x10¹⁹/cm³ is formed within the P⁻-type silicon substrate 1, and an N⁺-type impurity region W' having an impurity concentration of more than 1×10¹⁹/cm³ is formed within the N⁻-type well region W.

Thus, in Figs. 32 and 33, since the impurity concentration of the P⁺-type impurity region 1 for the N-channel transistor Qₙ and the impurity concentration of the N⁺ impurity region W' are both high, even when the voltage applied to the source region 3S-2 is increased, a depletion region is hardly generated in the silicon substrate 1' beneath the channel region 3C-1 of the N-channel transistor Qₙ and in the N⁺-type well region W' beneath the channel region 3C-2 of the P-channel transistor Qₚ.

The CMOS device of Fig. 32 can be manufactured by the steps as illustrated in Figs. 11A to 11D in combination with a conventional CMOS manufacturing process. Also, the CMOS device of Fig. 33 can be manufactured by the steps as illustrated in Figs. 13A to 13D in combination with a conventional CMOS manufacturing process.

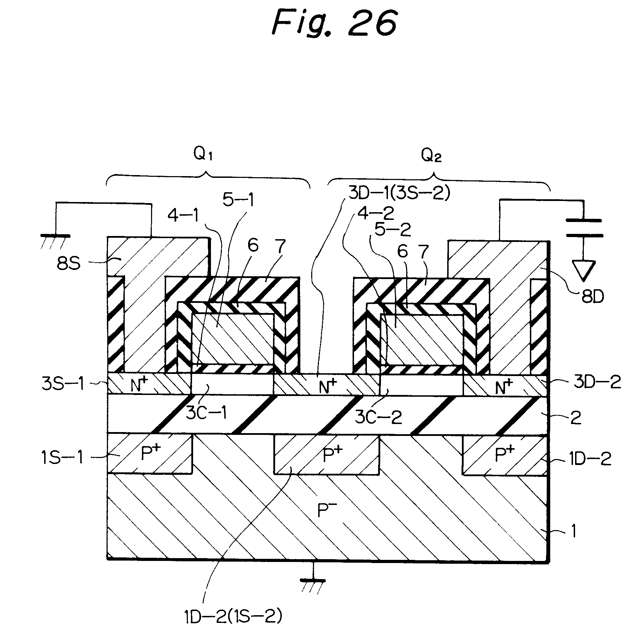

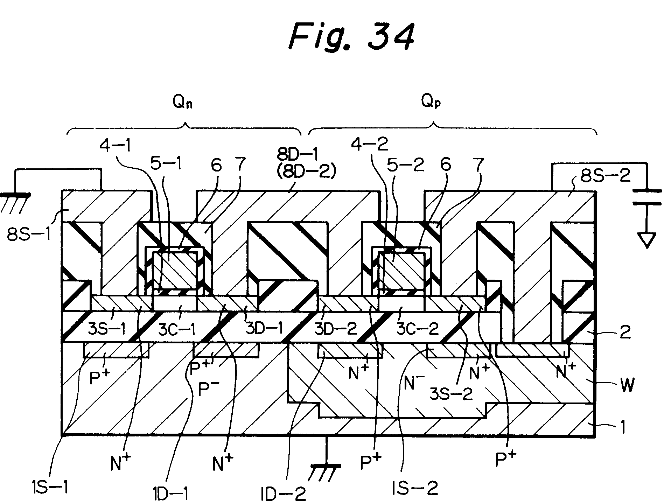

In Fig. 34, which illustrates a twenty first embodiment of the present invention, the thirteenth embodiment as illustrated in Fig. 26 is applied to a CMOS circuit formed by a P-channel transistor Q ₚ and an N-channel transistor Qₙ. That is, impurity highly doped P ⁺-type regions 1S-1 and 1D-1 beneath the source region 3S-1 and the drain region 3D-1, respectively, of the N-channel transistor Qₙ are provided, and impurity highly doped N⁺-type regions 1S-2 and 1D-2 beneath the source region 3S-2 and the drain region 3D-2, respectively, of the P-channel transistor Qₚ are provided. In this case, the impurity highly doped regions are about 500 nm thick and have an impurity concentration of more than 1×10¹⁹/ cm³.

Also in Fig. 34, since the impurity concentration of the impurity doped regions is high, even when the voltage applied to the drain region 3S-2 is increased, a depletion region is hardly grown in the silicon substrate 1 beneath the channel region 3C-1 and in the P⁻-type well region W beneath the channel region 3C-2.

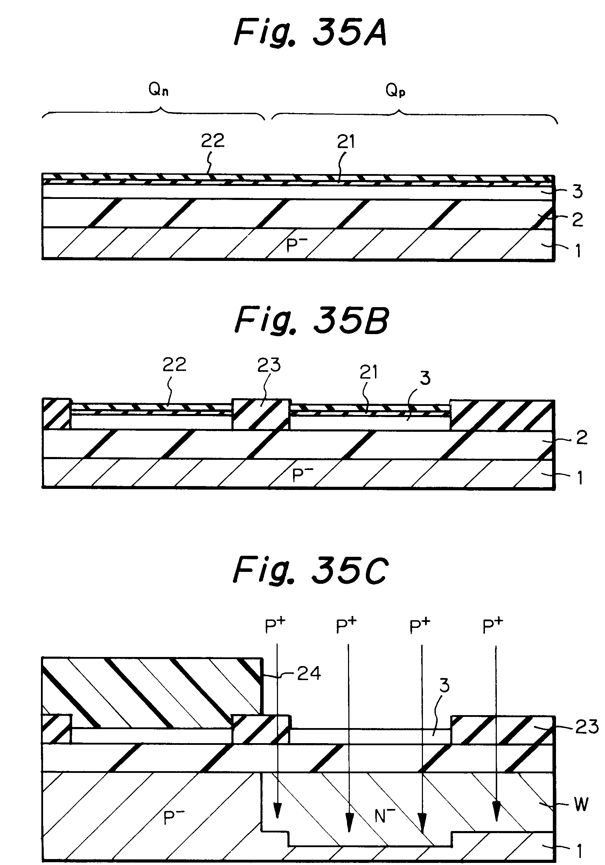

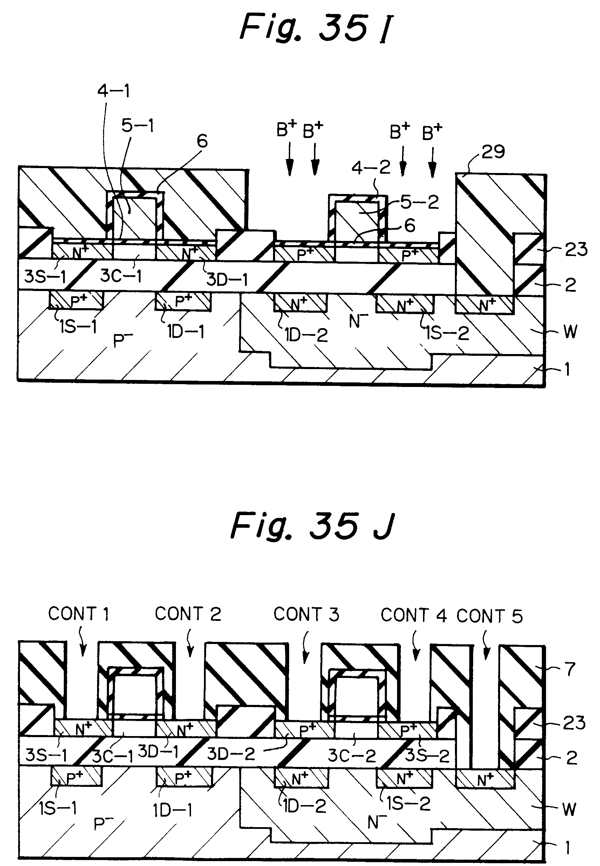

The manufacture of the device of Fig. 34 is explained next with reference to Figs. 35A through 35J.

First, referring to Fig. 35A, a SOI substrate formed by an impurity lightly doped P-type monocrystalline silicon substrate 1, an about 90 nm thick silicon oxide layer 2 and an about 500 nm thick impurity lightly doped silicon layer 3 is prepared. For example, about 4×10¹⁷ oxygen ions/cm are implanted at an acceleration energy of about 180 keV into an impurity lightly-doped P-type (100) monocrystalline silicon substrate whose temperature is about 550°C, and thereafter, a heat operation at about 1350°C is performed thereupon for about six hours. Thus, the SOI substrate of Fig. 35A is obtained.

Note that the thickness of the silicon layer 3 can be arbitrarily and precisely adjusted by thermally oxidizing it and etching the resulting silicon oxide.

Next, an about 30 nm thick silicon oxide layer 21 is formed by thermally oxidizing the silicon layer 3, and subsequently, a silicon nitride layer 22 is deposited thereon by a CVD process.

Next, referring to Fig. 35B, the silicon oxide layer 21 is patterned by a photolithography and dry etching process, so that a part of the silicon nitride layer 22 corresponding to element isolation areas is removed. Then, a thermal heat operation is performed upon the silicon layer 3 with a mask of the silicon nitride layer 22, to form a field thick silicon oxide layer 23. This silicon oxide layer 23 is about 200 nm thick, and reaches the silicon oxide layer 3. Then, the silicon nitride layer 22 is removed by hot phosphoric acid, and the silicon oxide layer 21 is removed by diluted fluoric acid.

Next, referring to Fig. 35C, a photoresist pattern 24 is formed by a photolithography process to cover the N-channel transistor Qₙ area. Then, 1×10¹ phosphorous ions/cm are implanted at an acceleration energy of about 300 keV into the silicon substrate 1 with a mask of the photoresist pattern 24. Thus, an N⁺-type well region W is formed in the silicon substrate 1. Then, the photoresist pattern 24 is removed.

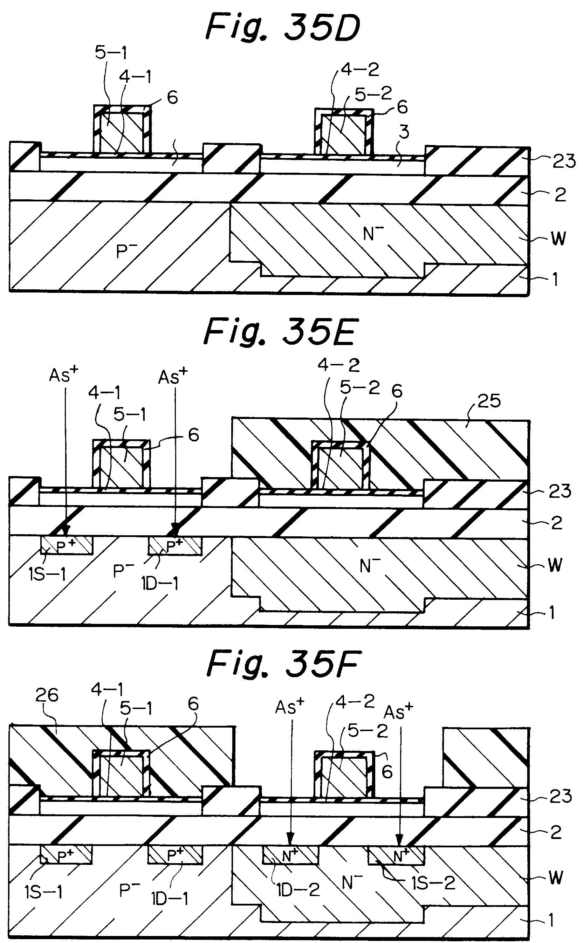

Next, referring to Fig. 35D, gate silicon oxide layer 4-1 and 4-2 are formed by thermally oxidizing the silicon layer 3, and an N-type impurity doped polycrystalline silicon layer is formed on the entire surface. Then, the polycrystalline silicon layer is patterned by a photolithography and dry etching process to form gate electrodes 5-1 and 5-2.

Next, referring to Fig. 35E, a photoresist pattern 25 is coated by a photolithography process to cover the P-channel transistor Qₚ area. Next, about 3× 10¹⁵ P-type impurities such as boron/cm are ion-implanted at an acceleration energy of about 80 to 100 keV into the P⁻-type silicon substrate 1 with a mask of the gate electrode 5-1 and the photoresist pattern 25, to thereby form P⁺-type impurity regions 1S-1 and 1D-1. Then, the photoresist pattern 25 is removed.

Next, referring to Fig. 35F, a photoresist pattern 26 is coated by a photolithography process to cover the N-channel transistor Qₙ area. Next, about 3× 10¹⁵ N-type impurities such as arsenic/cm are ion-implanted at an acceleration energy of about 80 to 100 keV into the N⁻-type well region W with a mask of the gate electrode 5-2 and the photoresist pattern 26, to thereby form N⁺-type impurity regions 1S-2 and 1D-2. Then, the photoresist pattern 26 is removed.

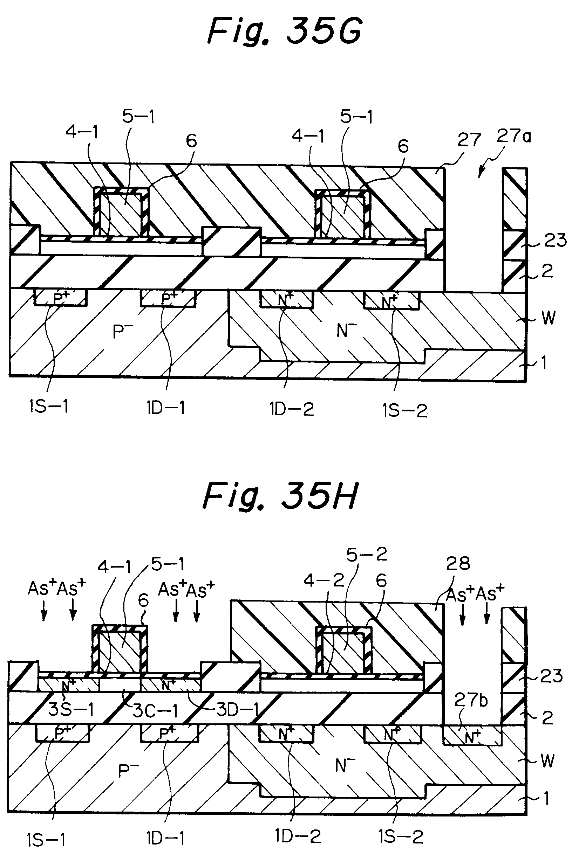

Next, referring to Fig. 35G, a photoresist pattern 27 is coated by a photolithography process. Then, the silicon oxide layers 23 and 2 are etched by a dry etching process with a mask of the photoresist pattern 27, to form a contact hole 27a. Then, the photoresist pattern 27 is removed.

Next, referring to Fig. 35H, a photoresist pattern 28 is coated by a photolithography process. Then, 5×10¹⁵ N-type impurities such as arsenic/cm are ion-implanted at an acceleration energy of about 50 keV with a mask of the gate electrode 5-1 and the photoresist pattern 28 into the silicon layer 3 and the P⁻-type well region W to form a source region 3S-1 and a drain region 3D-1 and a contact region 27b. In this case, a region of the silicon layer 3 sandwiched by the source region 3S-1 and the drain region 3D-1 is a channel region 3C-1. Then, the photoresist pattern 28 is removed.

Next, referring to Fig. 35I, a photoresist pattern 29 is coated by a photolithography process. Then, 5×10¹⁵ P-type impurities such as boron/cm are ion-implanted at an acceleration energy of about 50 keV with a mask of the gate electrode 5-2 and the photoresist pattern 29 into the silicon layer 3 to form a source region 3S-2 and a drain region 3D-2. In this case, a region of the silicon layer 3 sandwiched by the source region 3S-2 and the drain region 3D-2 is a channel region 3C-2. Then, the photoresist pattern 29 is removed.

Finally, referring to Fig. 35J, an about 500 nm thick silicon oxide layer 7 is formed by a CVD process, and contact holes CONT1 to CONT5 are perforated in the silicon oxide layer 7.

Then, an aluminum layer is deposited by a sputtering process and is patterned to form aluminum wirings 8S -1, 8D-1 (8D-2) and 8S-2, thus completing the device of Fig. 34.

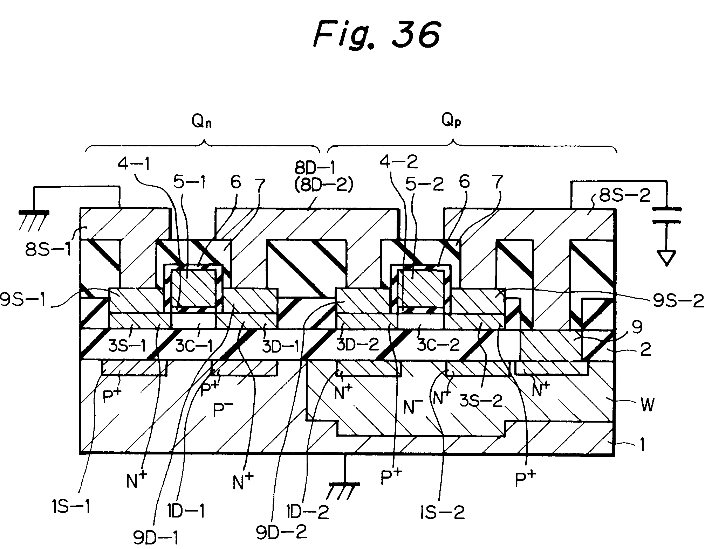

In Fig. 36, which illustrates a twenty second embodiment of the present invention, monocrystalline silicon layers 9S-1, 9D-1, 9D-2, 9S-2 and 9 are inserted between the aluminum wiring 8S-1 and the source region 3S-1, between the aluminum wiring 8D-1 and the drain region 3D-1, between the aluminum wiring 9D-2 and the drain region 3D-2, between the aluminum wiring 9S-2 and the source region 3S-2, and between the aluminum wiring 8S-2 and the contact region 27b. Thus, the parasitic resistance of the source and drain is remarkably decreased to increase the current drivability.

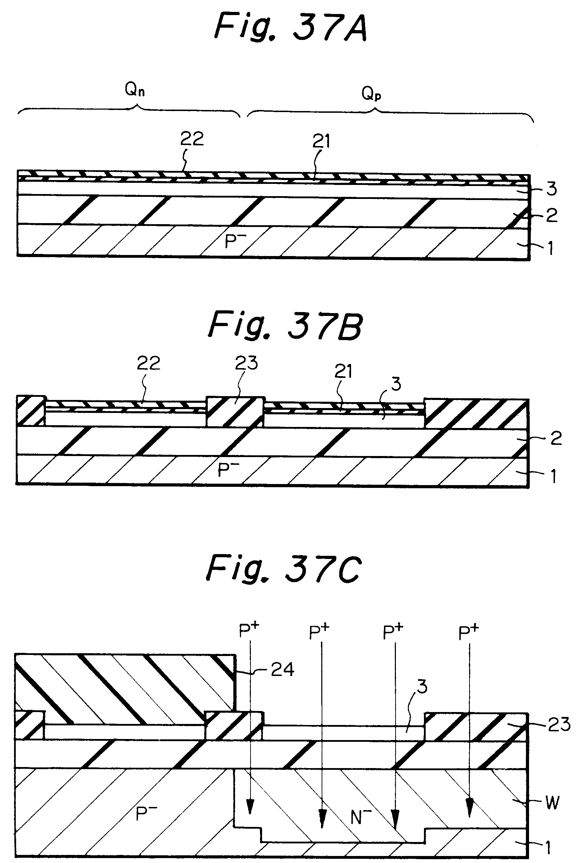

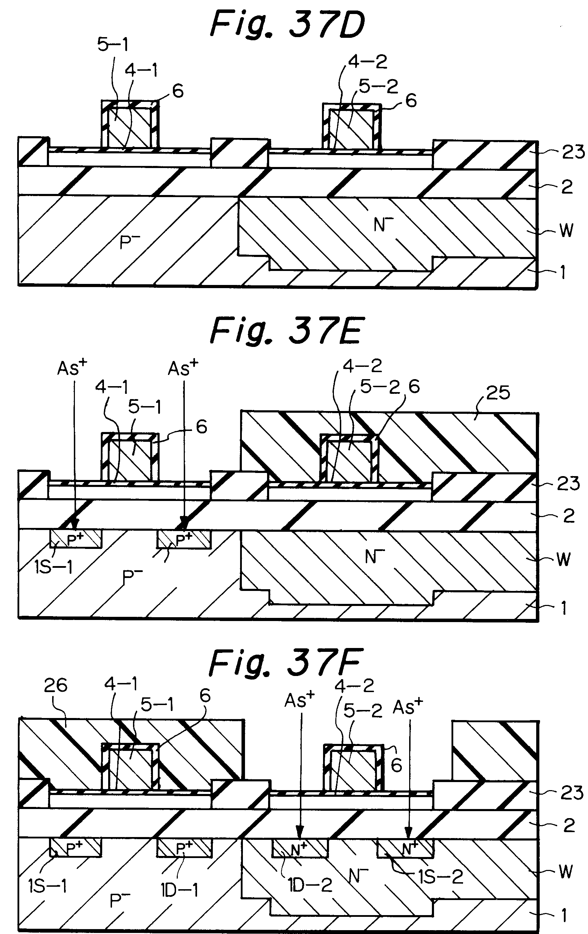

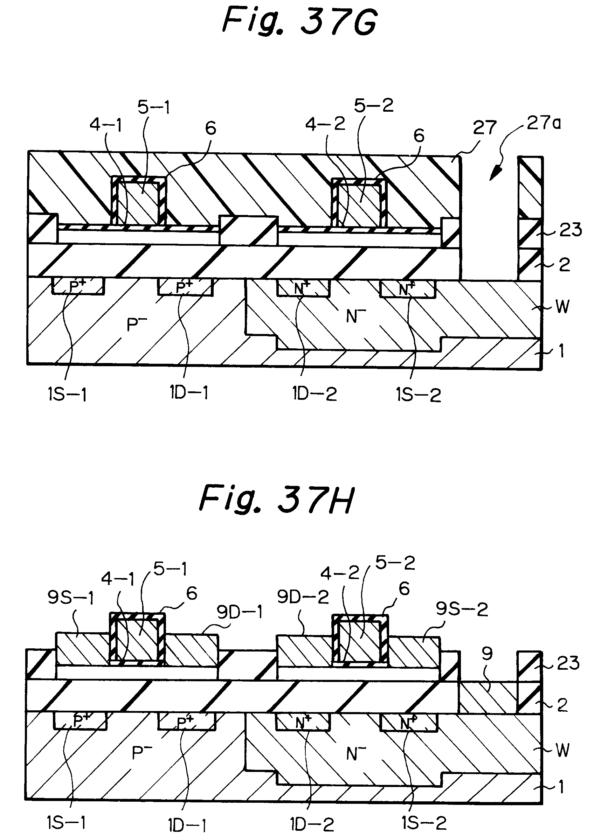

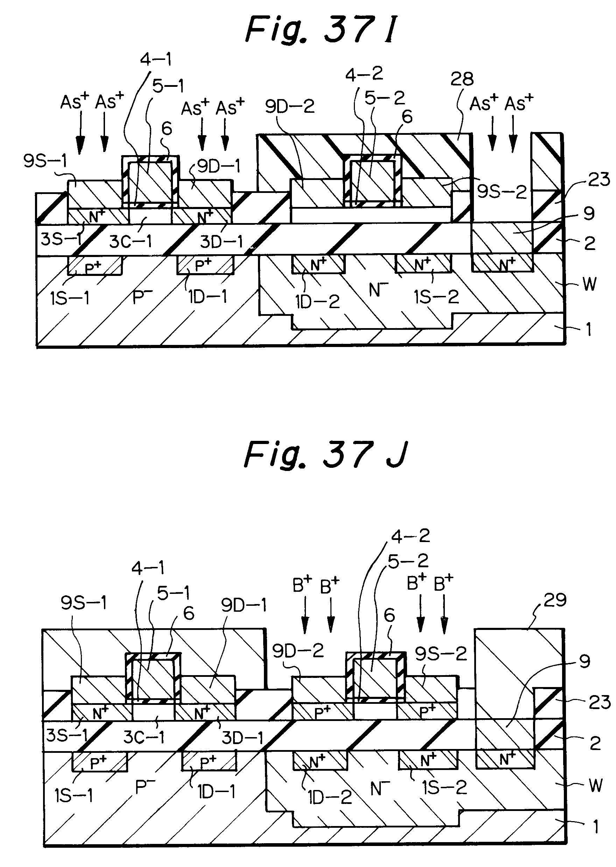

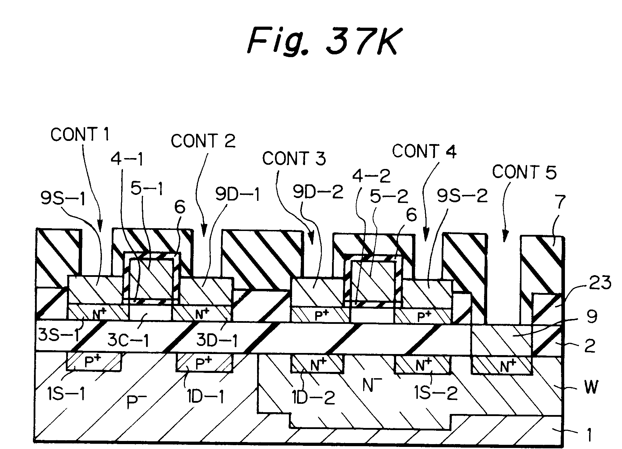

The manufacture of the device of Fig. 36 is explained next with reference to Figs. 37A through 37K.

First, referring to Figs. 37A through 37G, the manufacturing steps as illustrated in Figs. 35A through 35G are carried out.

Next, referring to Fig. 37H, about 100 nm thick monocrystalline silicon layers 9S-1, 9D-1, 9D-2, 9S-2 and 9 are grown by a selective epitaxial growth technology.

Finally, referring to Figs. 37I, 37J and 37K, the manufacturing steps as illustrated in Figs. 35H, 35I and 35J are carried out, to complete the device of Fig. 36.

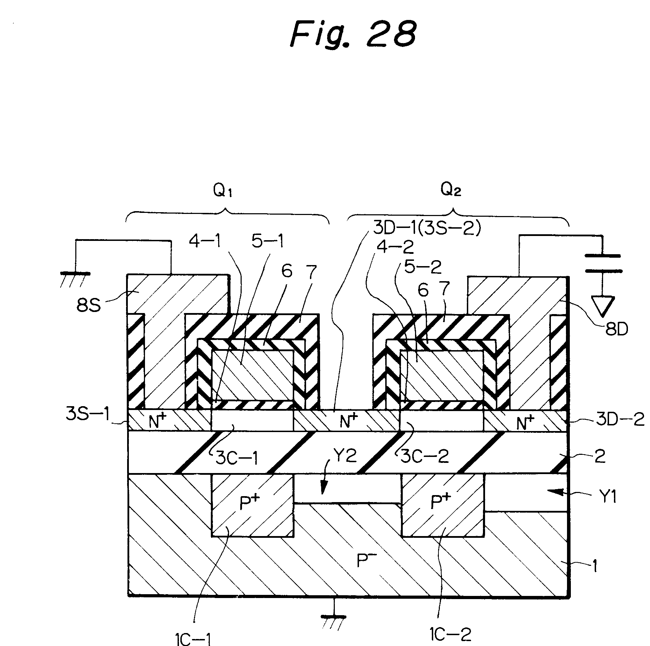

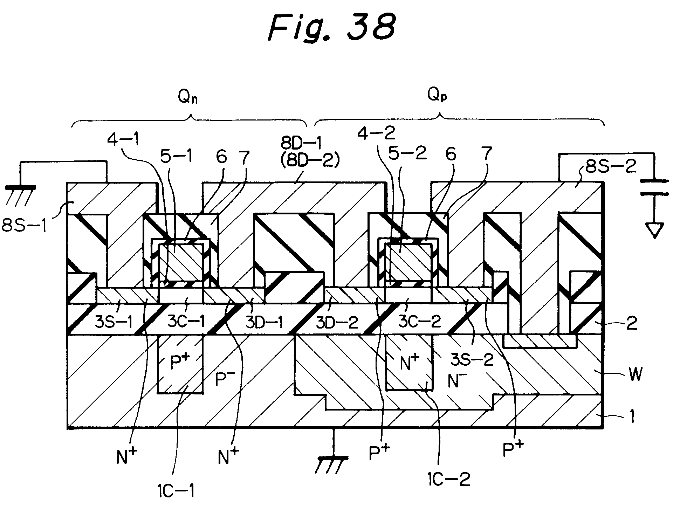

In Fig. 38, which illustrates a twenty third embodiment of the present invention, the fifteenth embodiment as illustrated in Fig. 28 is applied to a CMOS circuit formed by a P-channel transistor Qₚ and an N-channel transistor Qₙ. That is, an impurity highly doped P⁺-type region 1C-1 beneath the channel region 3C-1 of the N-channel transistor Qₙ is provided, and an impurity highly doped N⁺-type region 1C-2 beneath the an channel region 3C-2 of the P-channel transistor Qₚ is provided. In this case, the impurity highly doped regions is about 500 nm thick and have an impurity concentration of more than 1×10¹⁹/ cm³.

Also in Fig. 38, since the impurity concentration of the impurity doped region is high, even when the voltage applied to the drain region 3S-2 is increased, a depletion region is hardly grown in the silicon substrate 1 beneath the channel region 3C-1 and in the P⁻-type well region W beneath the channel region 3C-2.

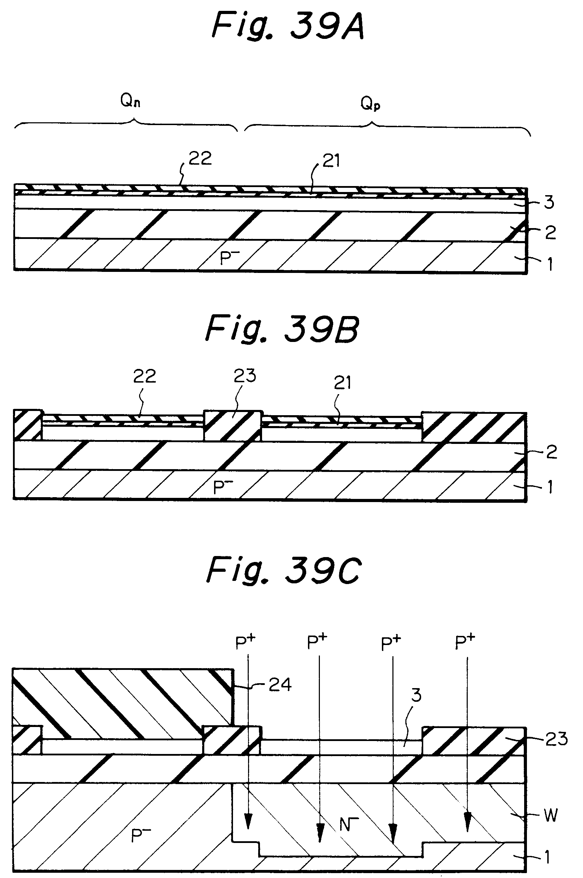

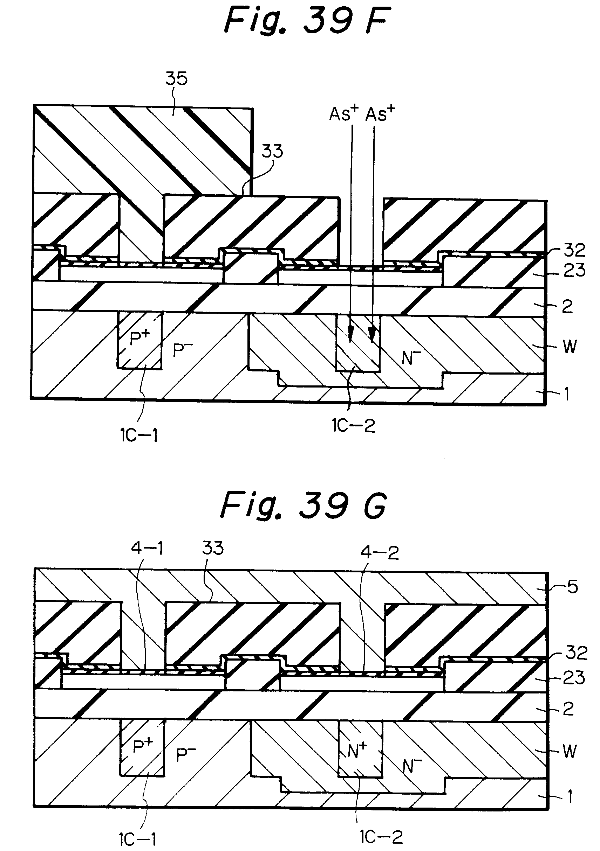

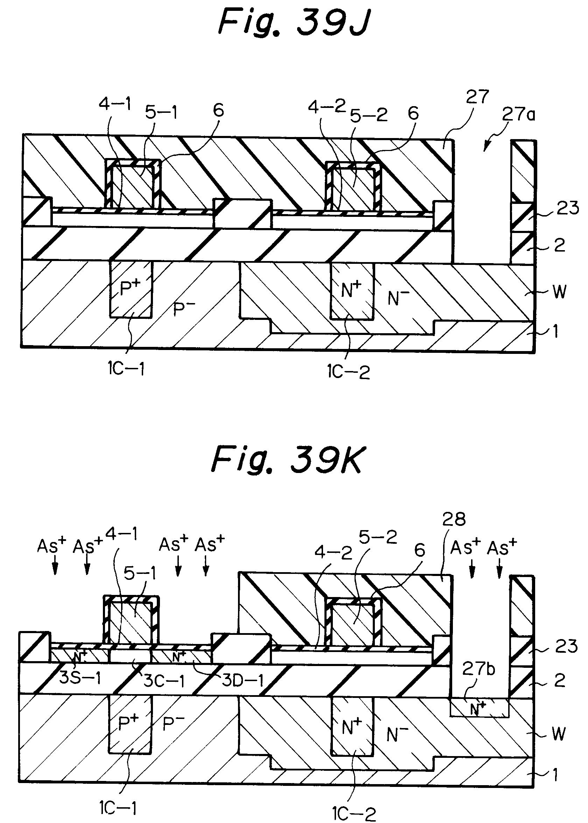

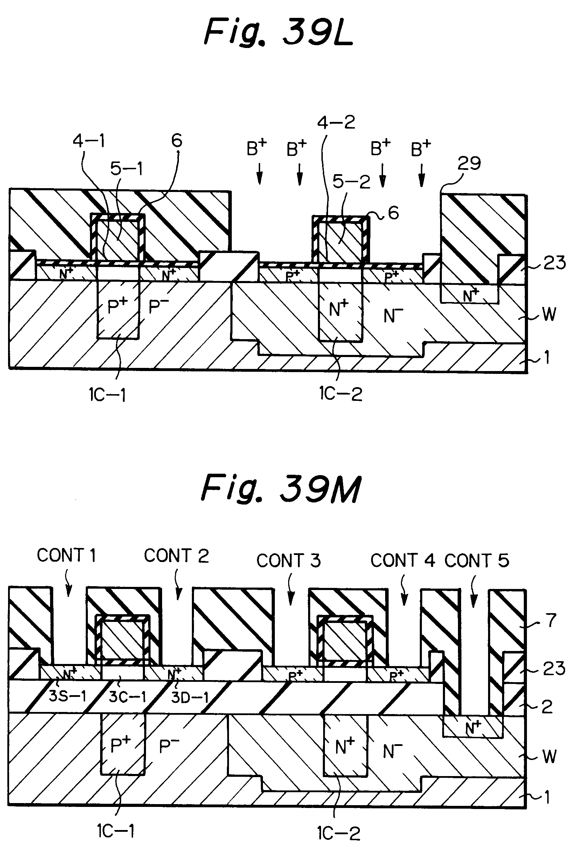

The manufacture of the device of Fig. 38 is explained next with reference to Figs. 39A through 39M.

First, referring to Fig. 39A, in the same way as shown in Fig. 35A, a SOI substrate formed by an impurity lightly doped P-type monocrystalline silicon substrate 1, an about 90 nm thick silicon oxide layer 2 and an about 50 nm thick impurity lightly doped silicon layer 3 is prepared. For example, about 4×10¹⁷ oxygen ions/cm are implanted at an acceleration energy of about 180 keV into an impurity lightly-doped P-type (100) monocrystalline silicon substrate whose temperature is about 550°C, and thereafter, a heat operation at about 1350°C is performed thereupon for about six hours. Thus, the SOI substrate of Fig. 39A is obtained.

Note that the thickness of the silicon layer 3 can be arbitrarily and precisely adjusted by thermally oxidizing it and etching the resulting silicon oxide.

Next, an about 30 nm thick silicon oxide layer 21 is formed by thermally oxidizing the silicon layer 3, and subsequently, a silicon nitride layer 22 is deposited thereon by a CVD process.

Next, referring to Fig. 39B, in the same way as shown in Fig. 35B, the silicon oxide layer 21 is patterned by a photolithography and dry etching process, so that a part of the silicon nitride layer 22 corresponding to element isolation areas is removed. Then, a thermal heat operation is performed upon the silicon layer 3 with a mask of the silicon nitride layer 22, to form a field thick silicon oxide layer 23. This silicon oxide layer 23 is about 200 nm thick, and reaches the silicon oxide layer 3. Then, the silicon nitride layer 22 is removed by hot phosphoric acid, and the silicon oxide layer 21 is removed by diluted fluoric acid.

Next, referring to Fig. 39C, in the same way as shown in Fig. 35C, a photoresist pattern 24 is formed by a photolithography process to cover the N-channel transistor Qₙ area. Then, 1×10¹ phosphorous ions/cm are implanted at an acceleration energy of about 300 keV into the silicon substrate 1 with a mask of the photoresist pattern 24. Thus, an N⁺-type well region W is formed in the silicon substrate 1. Then, the photoresist pattern 24 is removed.

Next, referring to Fig. 39D, an about 10 nm thick silicon oxide layer 31 is formed by thermally oxidizing the silicon layer 3, and a silicon nitride layer 32 is deposited thereon by a CVD process. Further, an about 300 nm thick silicon oxide layer 33 is formed thereon by a CVD process. Then, a heat operation is carried out to anneal the N⁻-type well region W.

Next, contact holes 33a and 33b are perforated in the silicon oxide layer 33, the silicon nitride layer 32 and the silicon oxide layer 31, to expose the silicon layer 3.

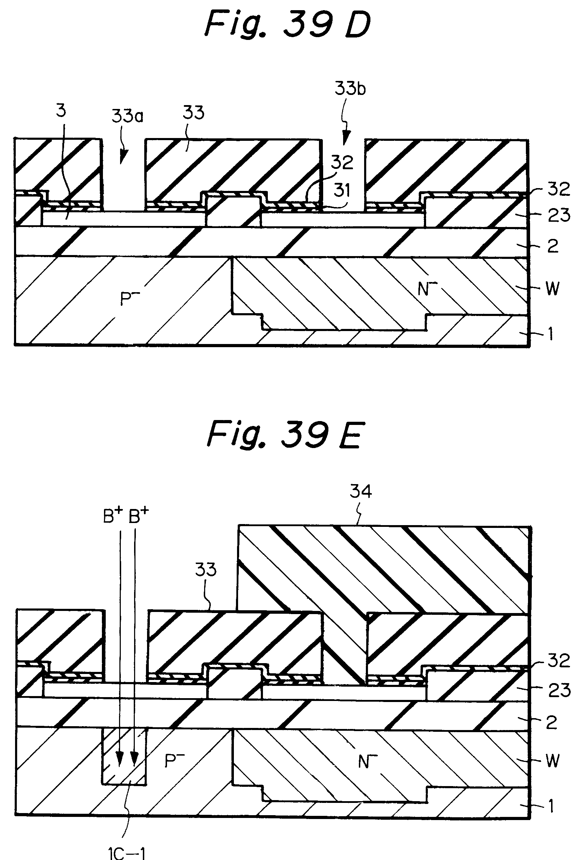

Next, referring to Fig. 39E, a photoresist pattern 34 is coated by a photolithography process to cover the P-channel transistor Qₚ area. Next, about 3× 10¹⁵ P-type impurities such as boron/cm are ion-implanted at an acceleration energy of about 80 to 100 keV into the P⁻-type silicon substrate 1 with a mask of the photoresist pattern 34, to thereby form a P⁺-type impurity region 1C-1. Then, the photoresist pattern 34 is removed.

Next, referring to Fig. 39F, a photoresist pattern 35 is coated by a photolithography process to cover the N-channel transistor Qₙ area. Next, about 3× 10¹⁵ N-type impurities such as arsenic/cm are ion-implanted at an acceleration energy of about 80 to 100 keV into the N⁻-type well region W with a mask of the photoresist pattern 35, to thereby form a N⁺-type impurity region 1C-2. Then, the photoresist pattern 35 is removed.

Next, referring to Fig. 39G, about 10 nm thick gate silicon oxide layers 4-1 and 4-2 are formed by thermally oxidizing the silicon layer 3. Then, an N-type impurity highly doped polycrystalline silicon layer 5 is deposited by a CVD process.

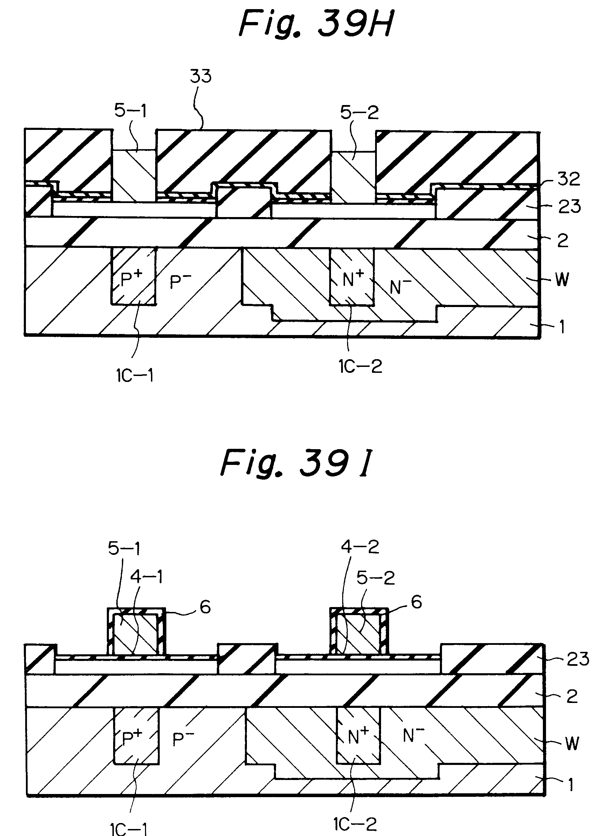

Next, referring to Fig. 39H, the polycrystalline silicon layer 5 is etched back by a dry etching process, to form gate electrodes 5-1 and 5-2. Then, the silicon oxide layer 33 is removed by diluted fluoric acid, and the silicon nitride layer 32 is removed by hot phosphoric acid.

Next, referring to Fig. 39I, a silicon oxide layer 6 is formed by thermally oxidizing the silicon layer 3 and the gate electrodes 5-1 and 5-2.

Next, referring to Fig. 39J, in the same way as shown in Fig. 35G, a photoresist pattern 27 is coated by a photolithography process. Then, the silicon oxide layers 23 and 2 are etched by a dry etching process with a mask of the photoresist pattern 27, to form a contact hole 27a. Then, the photoresist pattern 27 is removed.

Next, referring to Fig. 39K, in the same way as shown in Fig. 35H, a photoresist pattern 28 is coated by a photolithography process. Then, 5×10¹⁵ N-type impurities such as arsenic/cm are ion-implanted at an acceleration energy of about 50 keV with a mask of the gate electrode 5-1 and the photoresist pattern 28 into the silicon layer 3 and the P⁻-type well region W to form a source region 3S-1 and a drain region 3D-1 and a contact region 27b. In this case, a region of the silicon layer 3 sandwiched by the source region 3S-1 and the drain region 3D-1 is a channel region 3C-1. Then, the photoresist pattern 28 is removed.

Next, referring to Fig. 39L, in the same way as shown in Fig. 35I, a photoresist pattern 29 is coated by a photolithography process. Then, 5×10¹⁵ P-type impurities such as boron/cm are ion-implanted at an acceleration energy of about 50 keV with a mask of the gate electrode 5-2 and the photoresist pattern 29 into the silicon layer 3 to form a source region 3S-2 and a drain region 3D-2. In this case, a region of the silicon layer 3 sandwiched by the source region 3S-2 and the drain region 3D-2 is a channel region 3C-2. Then, the photoresist pattern 29 is removed.

Finally, referring to Fig. 39M, in the same way as shown in Fig. 35J, an about 500 nm thick silicon oxide layer 7 is formed by a CVD process, and contact holes CONT1 to CONT5 are perforated in the silicon oxide layer 7.

Then, an aluminum layer is deposited by a sputtering process and is patterned to form aluminum wirings 8S -1, 8D-1 (8D-2) and 8S-2, thus completing the device of Fig. 34.

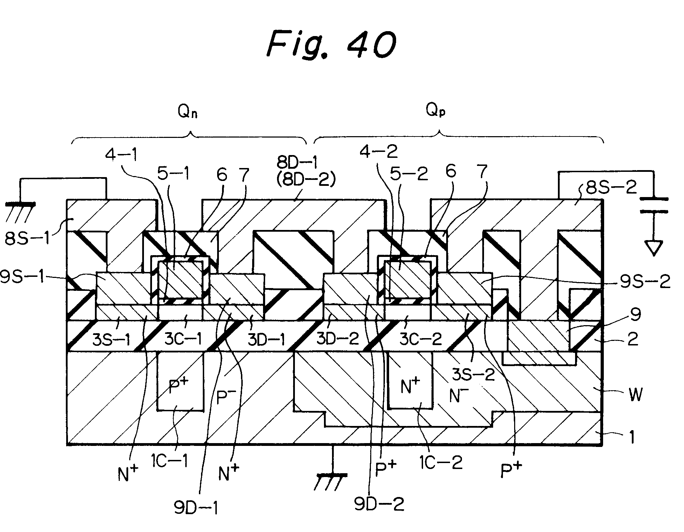

In Fig. 40, which illustrates a twenty fourth embodiment of the present invention, monocrystalline silicon layers 9S-1, 9D-1, 9D-2, 9S-2 and 9 are inserted between the aluminum wiring 8S-1 and the source region 3S-1, between the aluminum wiring 8D-1 and the drain region 3D-1, between the aluminum wiring 9D-2 and the drain region 3D-2, between the aluminum wiring 9S-2 and the source region 3S-2, and between the aluminum wiring 8S-2 and the contact region 27b. Thus, the parasitic resistance of the source and drain is remarkably decreased to increase the current drivability.

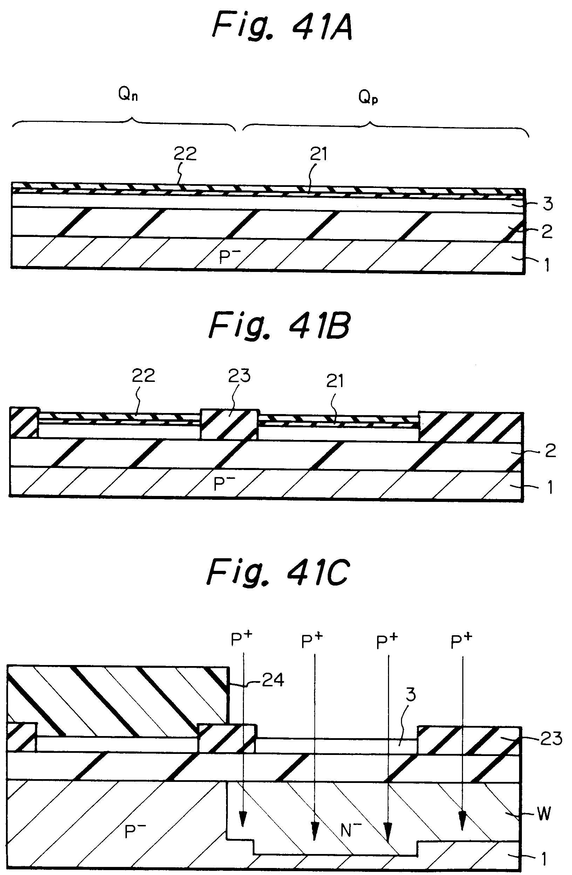

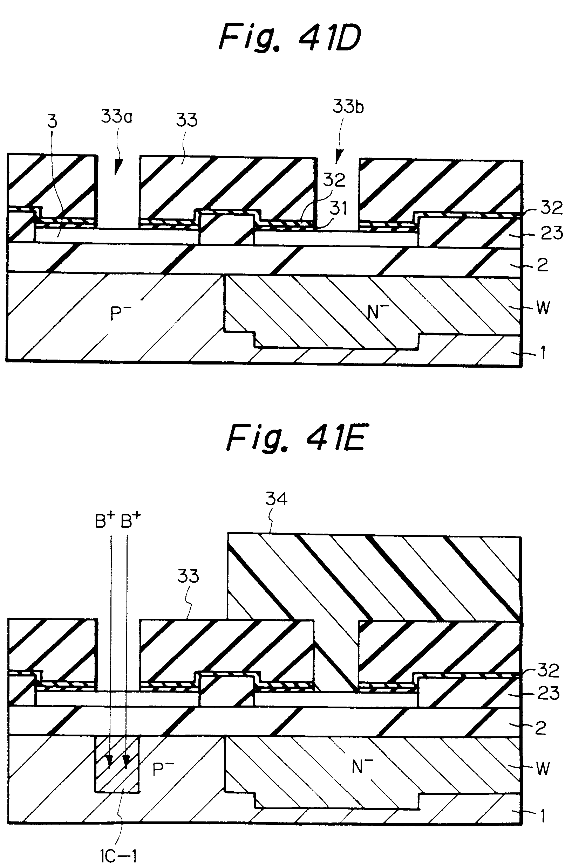

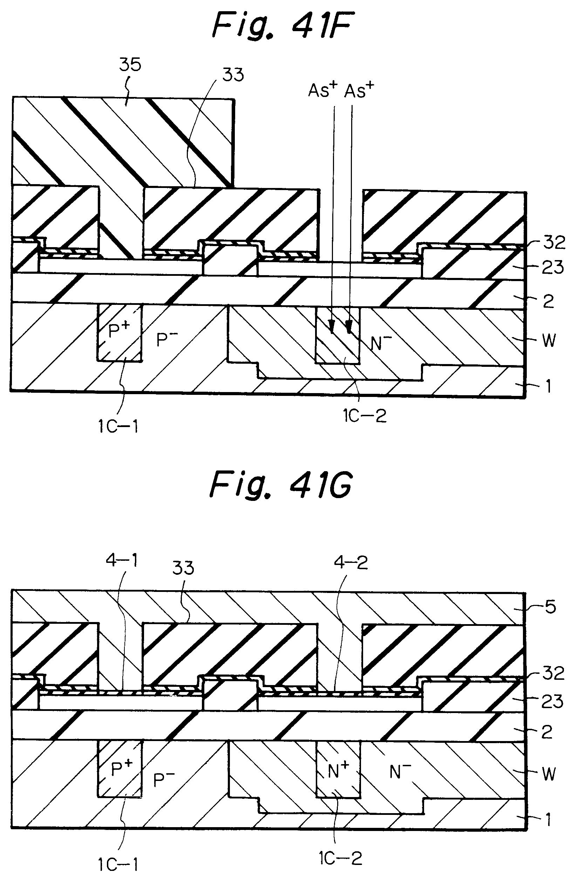

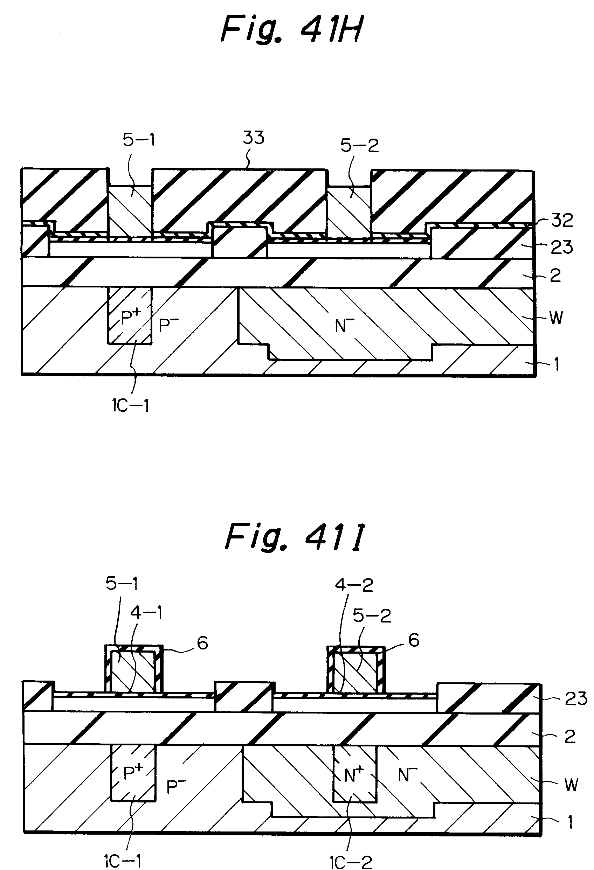

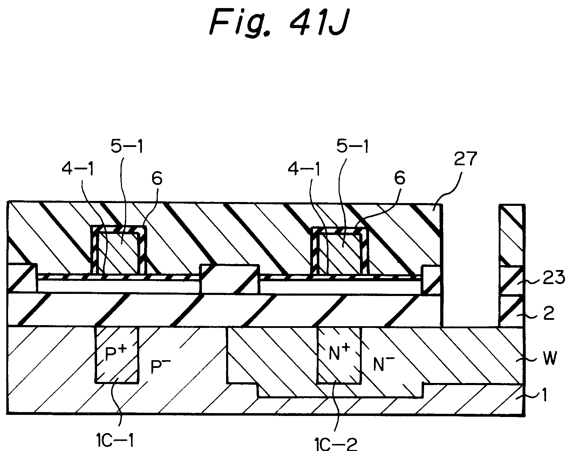

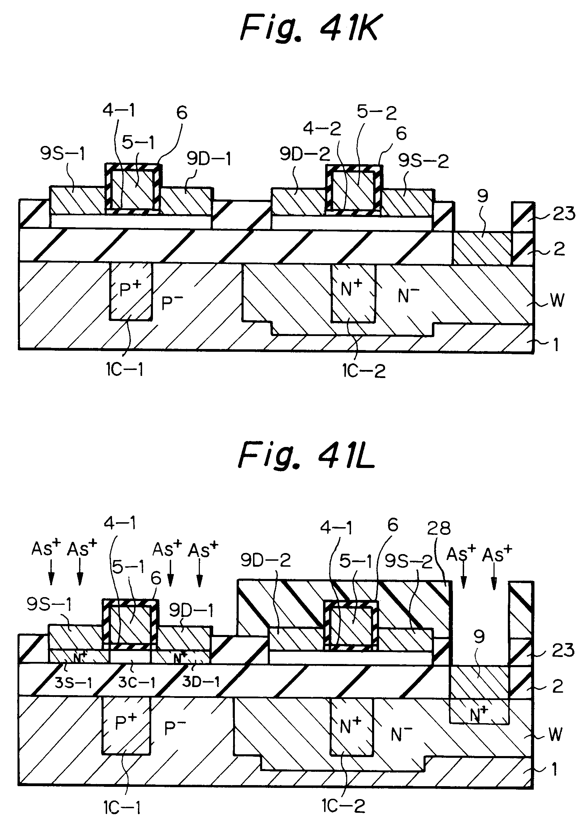

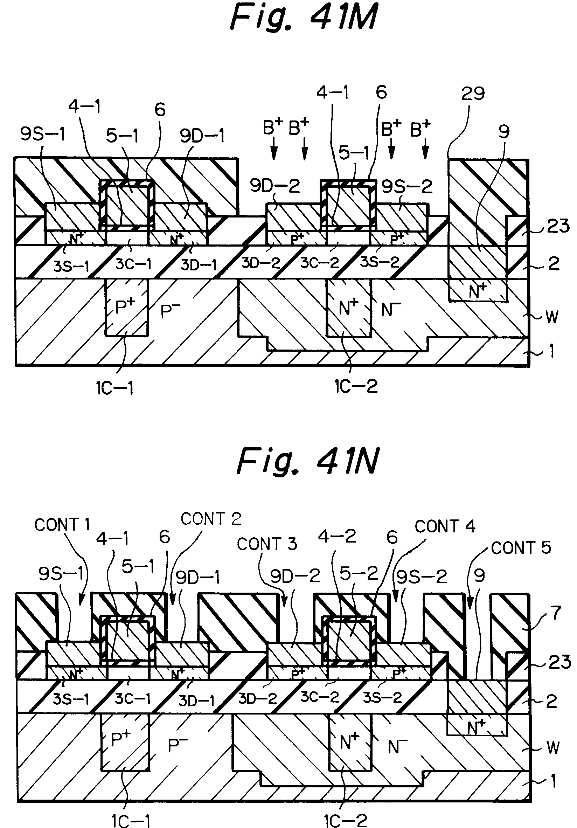

The manufacture of the device of Fig. 40 is explained next with reference to Figs. 41A through 41N.

First, referring to Figs. 41A through 41J, the manufacturing steps as illustrated in Figs. 39A through 39J are carried out.

Next, referring to Fig. 41K, about 100 nm thick monocrystalline silicon layers 9S-1, 9D-1, 9D-2, 9S-2 and 9 are grown by a selective epitaxial growth technology.

Finally, referring to Figs. 41L, 41M and 41N, the manufacturing steps as illustrated in Figs. 39K, 39L and 39M are carried out, to complete the device of Fig. 40.

In the above-described embodiments, it is possible to form metal silicide such as titanium silicide or cobalt silicide on the gate electrode 5 (5-1, 5-2). Also, tungsten or other metal can be used for the monocrystalline silicon layer 9S, 9S-1 and the like. Further, although a high impurity concentration of at least one part of the semiconductor is more than 1×10¹⁹/cm³, in the above-described embodiments, such a high impurity concentration can be more than 1x10¹⁶/cm³, preferably, more than 1×10¹⁸/cm³.

As explained hereinbefore, according to the present invention, since a depletion region is hardly generated within the silicon substrate beneath the channel region, the absolute value of the threshold voltage can be decreased, and accordingly, the channel mobility can be increased to increase the operation speed.

## Claims

1. A semiconductor device comprising;
a semiconductor substrate (1, 1');
an insulating layer (2) formed on said semiconductor substrate; and
a semiconductor layer (3) formed on said insulating layer,
at least one part of said semiconductor substrate in the proximity of said insulating layer having an impurity concentration larger than approximately 1×10¹⁶/cm³.

2. A device as set forth in claim 1, wherein semiconductor substrate is made of monocrystalline silicon.

3. A device as set forth in claim 1, wherein said insulating layer is made of silicon oxide.

4. A device as set forth in claim 1, wherein said semiconductor layer is made of monocrystalline silicon.

5. A device as set forth in claim 1, wherein said semiconductor substrate comprises:
a first portion (1) in the proximity of said insulating layer, said first portion having an impurity concentration larger than approximately 1×10¹⁶/cm³; and
a second portion (1a) apart from said insulating layer, said second portion having an impurity concentration smaller then approximately 1×10¹⁶/cm³.

6. A device as set forth in claim 1, wherein said semiconductor layer comprises a source region (3S), a channel region (3C) and a drain region (3D) of a MIS transistor.

7. A device as set forth in claim 6, wherein said at least one part of said semiconductor substrate is arranged beneath said source region and said drain region.

8. A device as set forth in claim 6, wherein said at least one part of said semiconductor substrate is arranged beneath said channel region.

9. A device as set forth in claim 6, further comprising:
a first metal layer (9S) connected to said source region;
a first wiring layer (8S) connected to said first metal layer, said first metal layer being wider than said first wiring layer;
a second metal layer (9D) connected to said drain region; and
a second wiring layer (8D) connected to said second metal layer, said second metal layer being wider than said second wiring layer.

10. A device as set forth in claim 1, wherein said semiconductor layer comprises a source region (3S-1), a channel region (3C-1) and a drain region (3D-1) of a first MIS transistor (Q₁), and a source region (3S-2), a channel region (3C-2) and a drain region (3D-2) of a second MIS transistor (Q₂), said drain region of said first MIS transistor being in common with said source region of said second MIS transistor.

11. A device as set forth in claim 10, wherein said at least one part of said semiconductor substrate is arranged beneath said source region and said drain region of said first MIS transistor and beneath said source region and said drain region of said second MIS transistor.

12. A device as set forth in claim 10, wherein said at least one part of said semiconductor substrate is arranged beneath said channel regions of said first and second MIS transistors.

13. A device as set forth in claim 10, further comprising:
a first metal layer (9S-1) connected to said source region of said first MIS transistor;
a first wiring layer (8S) connected to said first metal layer, said first metal layer being wider than said first wining layer;
a second metal layer (9D-1, 9S-2) connected to said drain region of said first MIS transistor and said source region of said second MIS transistor;
a third metal layer (9D-2) connected to said drain region of said second MIS transistor; and
a second wiring layer (8D) connected to said third metal layer, said third metal layer being wider than said second wiring layer.

14. A device as set forth in claim 1, wherein said semiconductor substrate comprises:
a first impurity region (1) of a first conductivity type having an impurity concentration larger than approximately 1×10¹⁶/cm³;
a second impurity region (1a) of a second conductivity type opposite to said first conductivity type having an impurity concentration larger than approximately 1×10¹⁶/cm³;
said semiconductor layer comprising a source region (3S-1), a channel region (3C-1) and a drain region (3D-1) of a first MIS transistor (Qₙ) of said second conductivity type, and a drain region (3D-2), a channel region (3C-2) and a source region (3S-2) of a second MIS transistor (Qₚ) of said first conductivity, said drain region of said first MIS transistor being connected to said drain region of said second MIS transistor.

15. A device as set forth in claim 14, further comprising:
a first metal layer (9S-1) connected to said source region of said first MIS transistor;
a first wiring layer (8S-1) connected to said first metal layer, said first metal layer being wider than said first wiring layer;
a second metal layer (9D-1) connected to said drain region of said first MIS transistor;
a third metal layer (3D-2) connected to said drain region of said second MIS transistor;
a second wiring layer (8D-1, 8D-2) connected to said second and third metal layers, said second and third metal layer being wider than said third coiring layer;
a fourth metal layer (9S-2) connected to said source region of said second MIS transistor; and
a third wiring layer (8S-2) connected to said fourth metal layer, said fourth metal layer being wider than said third wiring layer.

16. A device as set forth in claim 1, wherein said semiconductor substrate comprises:
a first impurity region (1) of a first conductivity type having an impurity concentration smaller than approximately 1×10¹⁶/cm³;
a second impurity region (1a) of said first conductivity type formed on said first impurity region and in the proximity of said insulating layer, said second impurity region having an impurity concentration larger than approximately 1×10¹⁶/cm³;
a third impurity region (W) of a second conductivity type opposite to said first conductivity type having an impurity concentration smaller than approximately 1×10¹⁶/cm³;
a fourth impurity region of said second conductivity type formed on said third impurity region and in the proximity of said insulating layer, said fourth impurity region having an impurity concentration larger than approximately 1×10¹⁶/cm³;
said semiconductor layer comprising a source region (3S-1), a channel region (3C-1) and a drain region (3D-1) of a first MIS transistor (Qₙ) of said first conductivity type, formed above said second impurity region, and a drain region (3D-2), a channel region (3C-2) and a source region (3S-2) of a second MIS transistor (Qₚ) of said second conductivity formed above said fourth impurity region, said drain region of said first MIS transistor being connected to said drain region of said second MIS transistor.

17. A device as set forth in claim 16, further comprising:
a first metal layer (9S-1) connected to said source region of said first MIS transistor;
a first wiring layer (8S-1) connected to said first metal layer, said first metal layer being wider than said first wiring layer;
a second metal layer (9D-1) connected to said drain region of said first MIS transistor;
a third metal layer (9D-2) connected to said drain region of said second MIS transistor;
a second wiring layer (8D-1, 8D-2) connected to said second and third metal layers, said second and third metal layers being wider than said second wiring layer;
a fourth metal layer (9S-2) connected to said source region of said second MIS transistor; and
a third wiring layer (8S-2) connected to said fourth metal layer, said fourth metal layer being wider than said third wiring layer.

18. A device as set forth in claim 16, wherein said second impurity region is arranged beneath said source region and said drain region of said first MIS transistor, said fourth impurity region being arranged beneath said source region and said drain region of said second MIS transistor.

19. A device as set forth in claim 16, wherein said second impurity region is arranged beneath said channel region of said first MIS transistor, said fourth impurity region being arranged beneath said channel region of said second MIS transistor.

20. A semiconductor device comprising:
a semiconductor substrate (1) of a first conductivity type having a first impurity concentration;
an impurity layer (1') of said first conductivity type, being formed on said semiconductor substrate and having a second impurity concentration larger than said first impurity concentration;
an insulating layer (2) formed on said impurity layer; and
a semiconductor layer (3) formed on said insulating layer.

21. A device as set forth in claim 20, wherein said semiconductor layer comprises a source region (3S), a channel region (3C) and a drain region (3D) of a MIS transistor of a second conductivity type opposite to said first conductivity type.

22. A secmiconductor device comprising:
a semiconductor substrate (1) of a first conductivity type;
first and second impurity regions (1S, 1D) of said first conductivity type, being formed in said semiconductor substrate and having a larger impurity concentration than said semiconductor substrate;
an insulating layer (2) formed on said semiconductor substrate; and
a semiconductor layer (3) formed on said insulating layer,
said semiconductor layer comprising a MIS transistor of a second conductivity type opposite to said first conductivity type including a source region (3S) above said first impurity region, a drain region (3D) above said second impurity region and a channel region (3C) between said source region and said drain region.

23. A semiconductor device comprising:
a semiconductor substrate (1) of a first conductivity type;
an impurity region (1C) of said first conductivity type, being formed in said semiconductor substrate and having a larger impurity concentration than said semiconductor substrate;
an insulating layer (2) formed on said semiconductor substrate; and
a semiconductor layer (3) formed on said insulating layer,
said semiconductor layer comprising a MIS transistor of a second conductivity type opposite to said first conductivity type including a source region (3S), a drain region (3D) and a channel region (3C) above said impurity region between said source region and said drain region.

24. A semiconductor device comprising:
a semiconductor substrate (1) of a first conductivity type connected to a first power supply terminal (GND);
an impurity well region (W) of a second conductivity type opposite to said first conductivity type, being formed in said semiconductor substrate and connected to a second power supply terminal;
an insulating layer (2) formed on said semiconductor substrate; and
a semiconductor layer (3) formed on said insulating layer,
said semiconductor layer comprising a first MIS transistor of said first conductivity type including a source region (1S-1), a drain region (1D-1) and a channel region (1C-1) therebetween arranged above said semiconductor substrate, and a second MIS transistor of said second conductivity type including a source region (1S-2), a drain region (1D-2) and a channel region (1C-2) therebetween arranged above said impurity well region.

25. A semiconductor device comprising:
a semiconductor substrate (1) of a first conductivity type;
a first rich impurity region (1') of said first conductivity type formed in said semiconductor substrate in a first area thereof, said rich first impurity region having a larger impurity concentration than said semiconductor substrate;
an impurity well region (W) of a second conductivity type opposite to said first conductivity type, being formed in said semiconductor substrate in a second area thereof;
a second rich impurity region (W') of said second conductivity type formed in said impurity well region, said second impurity region having a larger impurity concentration than said impurity well region;
an insulating layer (2) formed on said semiconductor substrate; and
a semiconductor layer (3) formed on said insulating layer,
said semiconductor layer comprising: a first MIS transistor (Qₙ) of said first conductivity type including a source region (1S-1), a drain region (1D-1) and a channel region (1C-1) therebetween, said first MIS transistor being arranged above said first rich impurity region; and a second MIS transistor (Qₚ) of said second conductivity type including a source region (1S-2), a drain region (1D-2) and a channel region (1C-2) therebetween, said second MIS transistor being arranged above said second rich impurity region.

26. A semiconductor device comprising:
a semiconductor substrate (1) of a first conductivity type;
first and second rich impurity regions (1S-1, 1D-1) of said first conductivity type formed in said semiconductor substrate in a first area thereof, said rich first impurity regions having a larger impurity concentration than said semiconductor substrate;
an impurity well region (W) of a second conductivity type opposite to said first conductivity type, being formed in said semiconductor substrate in a second area thereof;
third and fourth rich impurity regions (1S-2, 1D-2) of said second conductivity type formed in said impurity well region, said third and fourth impurity regions having a larger impurity concentration than said impurity well region;
an insulating layer (2) formed on said semiconductor substrate; and
a semiconductor layer (3) formed on said insulating layer,
said semiconductor layer comprising a first MIS transistor (Qₙ) of said first conductivity type including a source region (1S-1) above said first rich impurity region, a drain region (1D-1) above said second rich impurity region and a channel region (1C-1) therebetween, and a second MIS transistor (Qₚ) of said second conductivity type including a source region (1S-2) above said third rich impurity region, a drain region (1D-2) above said fourth rich impurity region and a channel region (1C-2) therebetween.

27. A semiconductor device comprising:
a semiconductor substrate (1) of a first conductivity type;
a first rich impurity region (1C-1) of said first conductivity type formed in said semiconductor substrate in a first area thereof, said rich first impurity region having a larger impurity concentration than said semiconductor substrate;
an impurity well region (W) of a second conductivity type opposite to said first conductivity type, being formed in said semiconductor substrate in a second area thereof;
a second rich impurity region (1C-2) of said second conductivity type formed in said impurity well region, said second impurity region having a larger impurity concentration than said impurity well region;
an insulating layer (2) formed on said semiconductor substrate; and
a semiconductor layer (3) formed on said insulating layer,
said semiconductor layer comprising: a first MIS transistor (Qₙ) of said first conductivity type including a source region (1S-1), a drain region (1D-1) and a channel region (1C-1) therebetween, said channel region of said first MIS transistor being arranged above said first rich impurity region; and a second MIS transistor (Qₚ) of said second conductivity type including a source region (1S-2), a drain region (1D-2) and a channel region (1C-2) therebetween, said channel region of said second MIS transistor being arranged above said second rich impurity region.
